(19) Europäisches Patentamt
European Patent Office
Office européen des brevets

(11) **EP 2 091 144 B1**

(12) **EUROPEAN PATENT SPECIFICATION**

(45) Date of publication and mention of the grant of the patent:
**06.12.2017 Bulletin 2017/49**

(21) Application number: **07830552.1**

(22) Date of filing: **25.10.2007**

(51) Int Cl.:
*H03F 3/24* (2006.01)     *H03F 1/32* (2006.01)
*H04B 1/04* (2006.01)     *H03F 1/02* (2006.01)

(86) International application number:
**PCT/JP2007/070818**

(87) International publication number:
**WO 2008/050833 (02.05.2008 Gazette 2008/18)**

(54) **TRANSMISSION METHOD AND TRANSMISSION DEVICE**

ÜBERTRAGUNGSVERFAHREN UND ÜBERTRAGUNGSEINRICHTUNG

PROCÉDÉ D'ÉMISSION ET DISPOSITIF D'ÉMISSION

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **25.10.2006 US 854072 P**
**14.12.2006 US 875084 P**

(43) Date of publication of application:
**19.08.2009 Bulletin 2009/34**

(73) Proprietor: **Panasonic Intellectual Property Management Co., Ltd.**
**Osaka-shi, Osaka 540-6207 (JP)**

(72) Inventors:
• **McCUNE, Earl**
  **Santa Clara, CA 95050 (US)**
• **DO, Gary**
  **Santa Clara, CA 95050 (US)**
• **LEE, Wayne**
  **Santa Clara, CA 95050 (US)**
• **FLOWERS, Dale**
  **Santa Clara, CA 95050 (US)**

(74) Representative: **Grünecker Patent- und Rechtsanwälte**
**PartG mbB**
**Leopoldstraße 4**
**80802 München (DE)**

(56) References cited:
**EP-A1- 1 710 918**     **JP-A- 2001 069 075**
**JP-A- 2004 535 735**     **JP-A- 2005 295 523**
**US-A1- 2005 135 502**     **US-A1- 2005 206 457**
**US-A1- 2006 046 666**

**Description**

Technical Field

The present invention relates to a transmitting apparatus and transmitting method using a power amplifier (hereinafter "PA").

Background Art

The cellular communication technique continues its development to meet users' demands for high speed and reliable communication. The first generation (1G), which is analogue communication systems, has been replaced by the second generation (2G), which is digital communication systems such as GSM (Global System for Mobile Communications). In these several years, these 2G systems are enhanced by introduction of GPRS (General Packet Radio Service), and data rates in EDGE wireless service, which is extended GSM, are enhanced. By this means, users can perform not only speech communication but also data communication. Currently, the third generation (3G) known as UMTS (Universal Mobile Telecommunications System) uses W-CDMA (Wide-Band Code Division Multiple Access), and is improved around the world to reliably perform speech communication and data communication at high speed.

While the advance of the cellular wireless system benefits users, more restrictive communication standards are specified because the necessity to realize greater data throughput and effectively utilize available radio frequencies (RF) has increased. These more restrictive standards require terminal manufactures for solutions for operating equipment according to more complex modulation schemes and higher power control conditions. For example, while GSM uses a constant envelope modulation scheme, the EDGE and W-CDMA techniques use finer non-constant envelope signals. With EDGE and W-CDMA, a radio transmitter of a terminal is required to control output power over a wide dynamic range. To be more specific, the EDGE standard requires a transmitter to have the capacity for controlling output power over a 30 dB range. On the other hand, with the W-CDMA standard, a transmitter is required to have the capacity for controlling output power over an 80 dB range.

The output power control over the wide dynamic range specified by the W-CDMA standard is performed because the W-CDMA wireless interface uses direct spreading CDMA signal scheme. In a system based on CDMA, all mobile terminals share the same radio resources. Accordingly, it is important not to use power more than necessary in each physical channel between the base station and mobile terminal. To achieve power control at this level, the W-CDMA system uses TPC (transmit power control) mechanism. That is, the base station in the network transmits TPC commands in the downlink (DL) direction to a mobile terminal. TPC commands require the mobile terminal to increase or decrease a transmission power level in uplink (UL) by, for example, +/- 1, 2, 3, or ... dB, and, by this means, the power level for the system is managed and maintained at a tolerance level.

Patent application US 2006/046666 A1 describes a transmission device, transmission output control method, and radio communication device having two operating modes. Either linear operating mode or saturation operating mode is set as the operating mode of a high-frequency power amplifier on the basis of an operating mode set signal. The gain of a variable gain amplifier provided in front of the high-frequency power amplifier and values of output voltage and bias current supplied from a supply voltage/bias current control circuit to the high-frequency power amplifier are switched. The gain of the variable gain amplifier in the saturation operating mode is formed so as to be higher by a predetermined value than that in the linear operating mode. Accordingly, the high-frequency power amplifier operates in the designated operating mode, so that the output transmission power range can be widened.

It is difficult for a conventional RF transmitter (for example, a transmitter using quadrature modulation) to achieve output power over a wide dynamic range. This is because a power amplifier (PA) utilized in such a transmitter is required to operate in a high linearity to prevent, for example, spectrum reproduction and unnecessary adjacent channel interference. This requirement of linearity causes a problem when a non-constant envelope signal scheme such as EDGE and W-CDMA is utilized. This is because a driving level of the PA needs to be decreased to prevent signal distortion due to clipping of a peak signal. Further, to secure signals in a reliable manner, additional linearization resources must be provided. Unfortunately, these efforts to secure the linearity lead to a decrease in the overall power efficiency.

The polar modulation transmitting apparatus provides an alternative method for avoiding the problem with the conventional transmitting apparatus based on quadrature modulation. As described below, a polar modulation transmitting apparatus uses low energy. This is because the PA is not required to operate in a high linearity and enables output power control over the wide dynamic range.

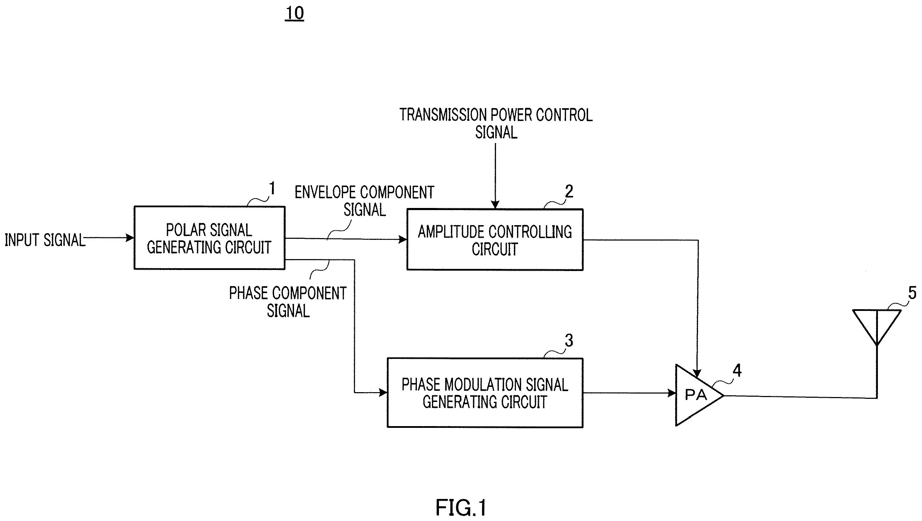

FIG.1 shows a configuration of typical polar modulation transmitting apparatus 10. As shown in FIG. 1, polar modulation transmitting apparatus 10 has polar signal generating circuit 1, amplitude controlling circuit 2, PA 4, antenna 5, and phase modulation signal generating circuit 3.

Polar signal generating circuit 1 operates according to an input signal, and generates an envelope component signal (hereinafter also referred to as an "amplitude component signal") containing information about the amplitude of the input signal and a phase component signal of a constant envelope containing information about the phase of the input signal. The envelope component signal is inputted in amplitude controlling circuit 2 along the amplitude path, and the phase component signal of a constant amplitude is inputted in phase modulation signal generating circuit 3. Phase modulation signal generating circuit 3 receives as input the phase component signal of a constant amplitude, generates a phase modulation RF signal of a constant amplitude, and inputs the phase modulation RF signal to an RF input of PA4 along the phase path. Amplitude controlling circuit 2 receives as input the envelope component signal along the amplitude path, and acquires the power supply voltage, which is determined according to a transmission power control signal received as input in the power control input terminal and which is subjected to amplitude modulation.

The power supply voltage subjected to amplitude modulation is inputted in the power supply input terminal of PA 4. By this means, PA 4 amplifies the phase modulation RF signal of a constant amplitude in the phase path according to the power supply voltage subjected to amplitude modulation. It may be said that the operation of this PA 4 is directed to combining the phase modulation RF signal and amplitude modulation signal. The output signal of PA 4 is emitted by antenna 5 and transmitted to the system base station.

Polar modulation transmitting apparatus 10 changes the signal envelope and controls output power by changing the gain of PA 4, so that the linearity of an RF circuit required in a conventional transmitting apparatus is not required. Further, output noise both inside the band and outside the band becomes substantially low compared to the conventional transmitting apparatus. Other advantages of polar modulation transmitting apparatus 10 include enabling output power control over a wide dynamic range. This is achieved by operating PA 4 in compressed mode in a period high transmission power is required and operating PA 4 in uncompressed mode in a period low transmission power is required.

In compressed mode, while the output power of transmitting apparatus 10 is controlled by the power supply voltage subjected to amplitude modulation and supplied to the collector (or drain) node of PA 4, the power of the phase modulation RF signal of the constant amplitude is maintained constant. In uncompressed mode, the output power of PA 4 is controlled by maintaining constant the scaling coefficient multiplied upon the envelope in the amplitude path and changing the scaling coefficient multiplied upon the driving signal in the phase path. However, it is not always necessary to maintain constant the scaling coefficient multiplied upon the envelope in the amplitude path.

Practically, compressed mode is fundamentally very accurate. On the other hand, the transmitting apparatus operates PA 4 in uncompressed mode in a less accurate state than in compressed mode.

Disclosure of Invention

Problems to be Solved by the Invention

However, with conventional transmitting apparatuses, when compressed mode ("c-mode") and uncompressed mode ("u-mode") switchintransmissionpower control, transmission power drift of maximum 5 dB or greater is likely to occur due to differences in characteristics between the modes (i.e. drift due to temperature, drift due to wear, and drift due to load, etc.).

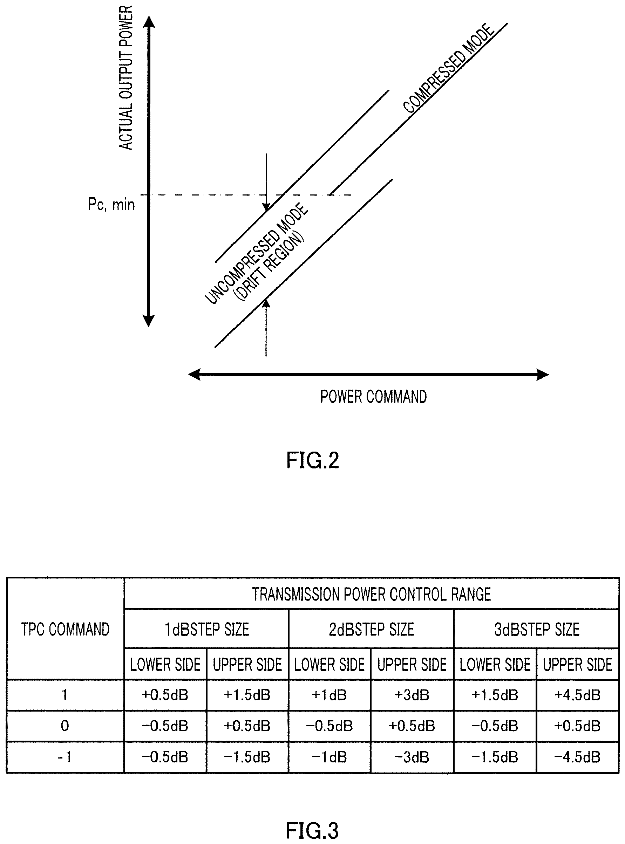

This will be explained briefly using FIG.2. As shown in FIG.2, the output power in compressed mode is relatively accurate, but output power in uncompressed mode changes due to drift (i.e. drift due to temperature, drift due to wear, and drift due to load, etc.).

As shown in FIG.2, output power in uncompressed mode is likely to drift due to various factors, and so, when compressed mode and uncompressed mode switch, output power in uncompressed mode is likely to be discontinuous, and, as a result, significant drift in transmission power is likely to occur.

For example, according to 3GPP (3rd Generation Partnership Project) 25.101, differences in transmission power need to fulfill the requirements shown in FIG.3 to FIG. 5. However, when compressed mode and uncompressed mode switch, it is difficult for conventional transmitting apparatuses to meet the requirements specified in 3GPP 25.101.

This will be explained in detail. Although, when a W-CDMA application requiring output power control of 80 dB is applied, polar modulation transmitting apparatus 10 is able to perfectly achieve output power over a wide dynamic range supporting this application, power control is difficult due to the difference in output power.

The 3GPP, which is the standardization body responsible for promoting UMTS and W-CDMA standards, requires a mobile terminal to increase or decrease its output power level in discrete steps (e.g., +/- 1 dB, +/- 2 dB, +/- 3 dB, etc.) according to TPC commands from a base station. The UMTS standard also specifies that these power increasing and decreasing steps be performed in a certain specified tolerance range.

For example, as shown in the table of FIG.3, in case of a TPC command for increasing and decreasing output power by a +/- 1 dB step, the resulting output power is required to be within +/- 0.5 dB of the target output power. Then, for example, when the transmitting apparatus of a mobile terminal operates at output power 0 dBm and receives a TPC command for "1, " the transmitting apparatus of the mobile terminal must adjust transmission power to be within the range between + 0.5 dBm and 1.5 dBm. Wider tolerance ranges such as +/- 1 dB and +/- 1.5 dB are allowed for larger step sizes of 2 dB and 3 dB.

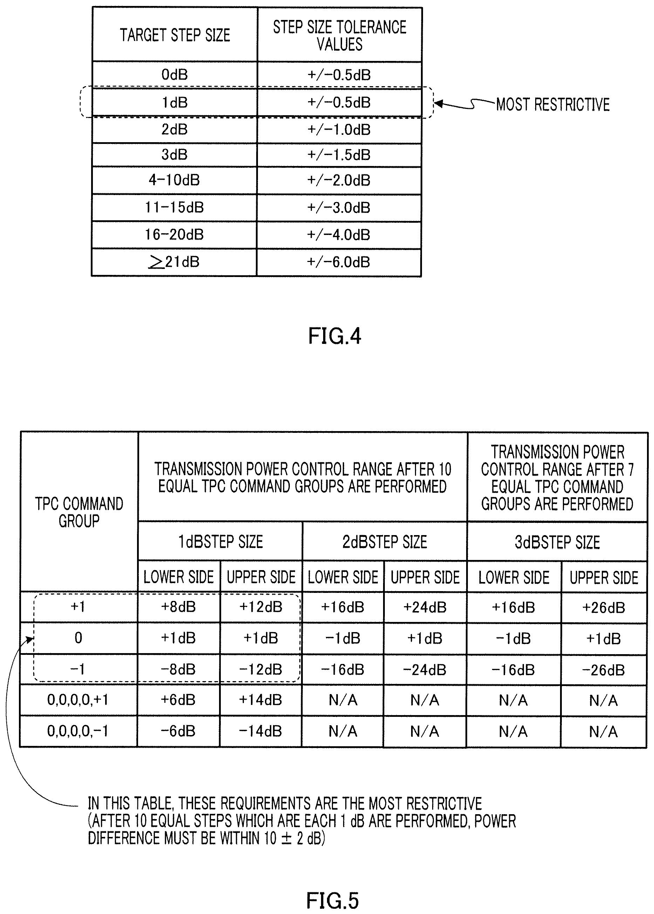

The 3GPP UMTS standard also specifies cumulative tolerance ranges for power command groups, as shown in the table in FIG.5. For example, ten TPC commands each configured with 1 dB step size, require that the output power level be within +/- 2 dB of the target output power level.

As shown in the list of the table of FIG.3 and FIG.4, the most restrictive step size for a single TPC command is associated with a TPC command showing +/- 1 dB (i.e. requiring +/- 0.5 dB tolerance).

Unfortunately, this tolerance value is not always satisfied in polar modulation transmitting apparatus 10 of FIG.1 in case of a power level step involving a mode switch from uncompressed mode to compressed mode.

Ideally, the output power level after the mode switch from uncompressed mode to compressed mode is continuous. When PA 4 operates in compressed mode, the step of the power level is very accurate. However, as shown in FIG.2, the discontinuity (or a "gap") in the output power curve is observed near a region where mode switches. Under a certain environment, it is observed that the discontinuity between the power level curve in compressed mode and the power level curve in uncompressed mode is so significant that a tolerance value such as +/- 0.5 dB for the 1 dB step size specified according to the UMTS standard, is not satisfied.

Accordingly, a method and an apparatus are desired that can control the discontinuity in transmission power such that the power level curve satisfies the requirements of power control accuracy in the wireless standard upon a mode switch in a polar modulation transmitting apparatus.

It is therefore an object of the present invention to provide a transmitting method and transmitting apparatus that can suppress drift in transmission power (i.e. discontinuity in output power) when fundamentally accurate compressed mode and less accurate uncompressed mode switch upon transmission power control.

SUMMARY OF THE INVENTION

The above problems and disadvantages of the prior art are solved by the present invention as claimed in the independent claims. Advantageous and preferred embodiments of the invention are defined by the dependent claims.

Means for Solving the Problem

One aspect of the transmitting method according to the present invention in a communication transmitting apparatus supporting two power amplifier operation modes of a compressed mode and an uncompressed mode, includes: a first mode switching step of switching between the compressed mode and the uncompressed mode with reference to an output power level of a power amplifier; a second mode switching step of switching between the compressed mode and the uncompressed mode without reference to the output power level of the power amplifier; and a selecting step of selecting between performing the first mode switching step and performing the second mode switching step.

An example of the transmitting method selects, in the selecting step, between performing the first mode switching step and performing the second mode switching step based on a transmission power control signal including information about a change level in transmission power.

An example of the transmitting apparatus employs a configuration including: a power amplifier that supports two operation modes of a compressed mode and an uncompressed mode; and a transmission power controlling section that switches between the two operation modes by controlling a phase modulation radio frequency signal and a power supply voltage supplied to the power amplifier and that suppresses a difference upon a mode switch between output power levels of the power amplifier in the two operation modes.

One example of the transmitting apparatus further includes a measuring section that measures the output power level of the power amplifier, and employs a configuration where the transmission power controlling section selects whether or not to suppress the difference between the output power levels using a measurement result in the measuring section based on a transmission power control signal including information about a change level in transmission power.

Advantageous Effect of the Invention

The present invention realizes a transmitting method and transmitting apparatus that can suppress drift in transmission power (i.e. discontinuity in output power) when compress mode and uncompressed mode switch upon transmission power control.

Brief Description of Drawings

FIG.1 is a block diagram showing a configuration example of a conventional polar modulation transmitting apparatus;
FIG.2 shows drift in transmission power (i.e. discontinuity in output power) due to a mode switch;

FIG.3 shows power control tolerance values for output power step size commands according to the 3GPP UMTS standard;

FIG.4 lists tolerance step sizes;

FIG.5 shows cumulative power control tolerance values for groups of power commands according to the 3GPP UMTS standard;

FIG.6 is a block diagram showing a configuration of a transmitting apparatus according to an embodiment of the present invention;

FIG.7 shows elements of output power, that is, amplitude (AM) path envelope scaling and phase (PM) path amplitude scaling, when a power amplifier of the transmitting apparatus of a polar modulation scheme of FIG.6 is configured with compressed mode, uncompressed mode and an overlap region;

FIG.8 shows a transition operation from compressed mode to uncompressed mode when output power in uncompressed mode is low;

FIG.9 shows a transition operation from compressed mode to uncompressed mode when output power in uncompressed mode is high;

FIG.10 shows a transition operation from uncompressed mode to compressed mode when output power in uncompressed mode is low;

FIG.11 shows a transition operation from uncompressed mode to compressed mode when output power in uncompressed mode is high;

FIG.12A shows a -1 dB step sequence from compressed mode to uncompressed mode when output power in uncompressed mode is high;

FIG.12B shows a -2 dB step sequence from compressed mode to uncompressed mode when output power in uncompressed mode is high;

FIG.12C shows a -3 dB step sequence from compressed mode to uncompressed mode when output power in uncompressed mode is high;

FIG.13 shows a transition operation from compressed mode to uncompressed mode when output power in uncompressed mode is high;

FIG.14 shows a -1 dB step sequence from compressed mode to uncompressed mode when output power in uncompressed mode is low;

FIG.15 shows a transition operation from compressed mode to uncompressed mode when output power in uncompressed mode is low;

FIG.16 shows a +1 dB step sequence from uncompressed mode to compressed mode when output power in uncompressed mode is low;

FIG.17 shows a transition operation from uncompressed mode to compressed mode when output power in uncompressed mode is low;

FIG.18 shows a +1 dB step sequence from uncompressed mode to compressed mode when output power in uncompressed mode is high;

FIG.19 shows in detail a transition operation from uncompressed mode to compressed mode when output power in uncompressed mode is high;

FIG. 20 shows various operation regions of the polar modulation transmitting apparatus according to an embodiment;

FIG.21 is a flowchart explaining the operation in compressed mode according to Embodiment 1;

FIG.22 is a flowchart explaining the operation in uncompressed mode according to Embodiment 1;

FIG.23 is a mode switch diagram showing processes in which the power amplifier of the transmitting apparatus in FIG.6 switch in power level step sizes of 1, 2 and 3 dB from uncompressed mode to compressed mode;

FIG.24A is a flowchart showing how the operation of switching uncompressed mode to compressed mode is performed by a power alignment algorithm in Embodiment 2 when the transmitting apparatus in FIG.6 starts in uncompressed mode; and

FIG.24B is a flowchart showing how the operation of switching uncompressed mode to compressed mode is performed by a power alignment algorithm in Embodiment 2 when the transmitting apparatus in FIG.6 starts in uncompressed mode.

Best Mode for Carrying Out the Invention

Embodiments of the present invention will be explained in detail below with reference to the accompanying drawings.

Although cases will be explained below with the following embodiments where the present invention is applied to a transmitting apparatus using a polar modulation scheme, the present invention is by no means limited to a case where the present invention is applied to a transmitting apparatus using a polar modulation scheme and is widely applicable to the transmitting apparatus using a power amplifier (PA). The present invention is suitable for use in, for example, mobile terminals.

(Embodiment 1)

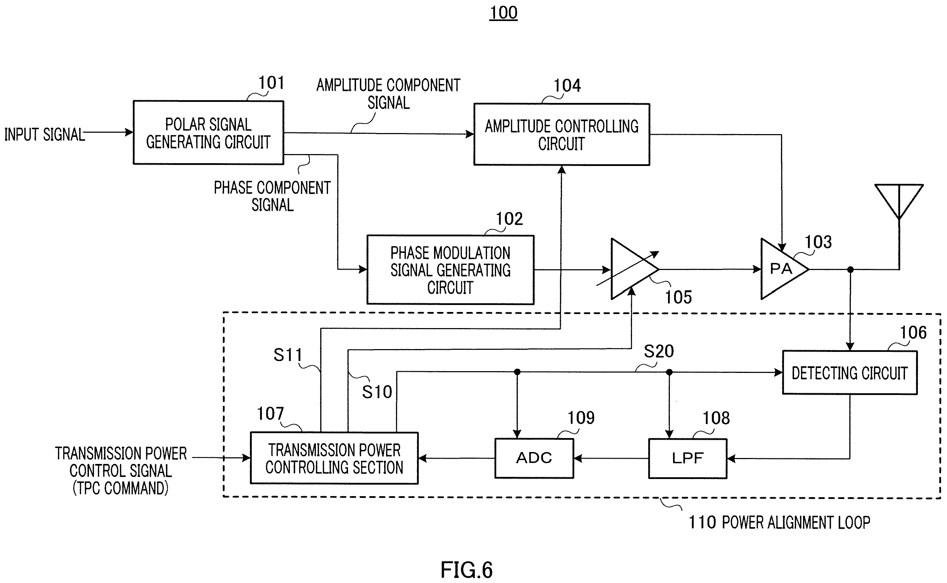

FIG.6 shows the configuration of a transmitting apparatus according to an embodiment of the present invention. Transmitting apparatus 100 has: polar signal generating circuit 101; phase modulation signal generating circuit 102; power amplifier (PA) 103; amplitude controlling circuit 104; variable amplifying circuit 105 formed with a variable gain amplifier (VGA) and/or an attenuator; antenna 111; and power alignment loop (PAL) 110. PAL 110 has detecting circuit 106 (for example, PIN diode or other semiconductor detector) that detects the output power of PA 103, low pass filter (LPF) 108, analogue-to-digital converter (ADC) 109 and transmission power controlling section 107.

Polar signal generating circuit 101 generates an amplitude component signal and a phase component signal from an input signal. To be more specific, polar signal generating circuit 101 operates according to the input signal, and generates an envelope component signal (i.e. amplitude component signal) containing information about the amplitude of the input signal and a constant-envelope component signal (i.e. phase component signal) containing information about the phase of the input signal. The envelope component signal is inputted to amplitude controlling circuit 104 along the amplitude path and the phase component signal of a constant amplitude is inputted to phase modulation signal generating circuit 102.

Phase modulation signal generating circuit 102 generates a phase modulation RF signal from the phase component signal. Variable amplifying circuit 105 amplifies and attenuates the phase modulation RF signal based on a phase path scaling coefficient (i.e. phase-path magnitude scaling) S10 obtained in PAL 110, and then supplies this scaled phase modulation RF signal to the RF signal input terminal of PA 103.

Amplitude controlling circuit 104 generates a power supply voltage of PA 103 by multiplying the amplitude component signal by amplitude path scaling coefficient (i.e. AM-path envelope scaling) S11 from transmission power controlling section 107, and supplies this power supply voltage to the power supply input terminal of PA 103.

Transmission power controlling section 107 receives as input an output of detecting circuit 106 through low pass filter (LPF) 108 and analogue-to-digital converter (ADC) 109. Further, transmission power controlling section 107 receives a transmission power control signal as input. Transmission power controlling section 107 forms phase path scaling coefficient S10 and amplitude path scaling coefficient S11 based on the transmission power control (TPC) command included in the transmission power control signal and the detection result in detecting circuit 106, and controls the transmission power of transmitting apparatus 100.

In practice, transmission power controlling section 107 transmits scaling coefficients S11 and S10 to amplitude controlling circuit 104 and variable amplifying circuit 105, respectively, to control the power supply voltage to PA 103 and the input signal (i.e. phase modulation RF signal) level in PA 103. Transmission power controlling section 107 calculates final scaling coefficients S10 and S11 by using the original values of scaling coefficients (phase scaling coefficients and amplitude scaling coefficients) obtained with reference to a table using the transmission power control signals (i.e. TPC commands) as addresses, and the correction values of scaling coefficients determined from the detection result in detecting circuit 106. That is, transmission power controlling section 107 of the present embodiment has a table associating TPC commands with scaling coefficients (hereinafter referred to as the "power table").

An example of a method of calculating scaling coefficients will be explained below. Assume that scaling coefficients in the power table are as shown in table 1.

[Table 1]

Table 1: examples of data set stored in the power table

| Address | Output power level setting value | Phase path scaling coefficient | Amplitude path scaling coefficient |
|---|---|---|---|
| 001 | -11 dBm | 90 | 100 |
| 002 | -10 dBm | 100 | 100 |
| 003 | - 9 dBm | 110 | 100 |
| 004 | - 8 dBm | 120 | 100 |
| ... | ... | ... | 100 |

Here, a method of calculating a phase path scaling coefficient will be explained with reference to a case where, when transmitting apparatus 100 operating in uncompressed mode "outputs a phase path scaling coefficient 100 at the output power -10 dBm in PA 103," transmission power control section 107 starts and decides to "increase the output power of PA 103 because the level difference from the output power level in the compressed mode operation is 0.3 dBm."

According to table 1, as the change from the phase path scaling coefficient "100" upon the uncompressed mode operation, the phase path scaling coefficient is set to "103" by adding an increase "+3" of the phase path scaling coefficient which corresponds to an increase "+0.3 dBm" of the output power level.

Further, to increase an output of PA 103 by only "+1 dBm," the above calculation needs not to be performed, and "address 003" adjacent to "address 002" storing scaling coefficient "100," may be referred to directly.

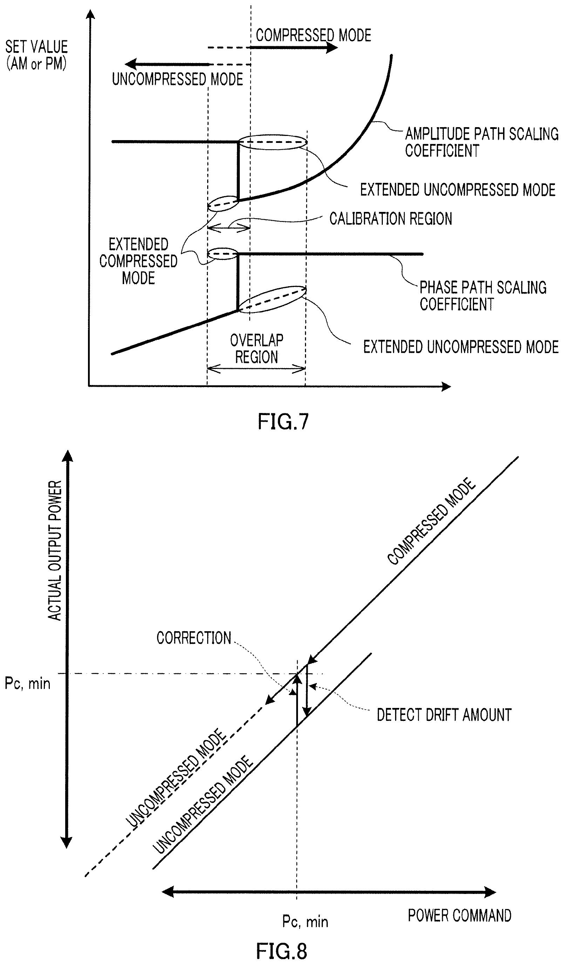

FIG.7 shows a scaling factor coefficient set in a power table provided in transmission power controlling section 107. In compressed mode, while the output power of transmitting apparatus 100 is controlled by the power supply voltage which is supplied to the collector (or drain) node of PA 103 and which has been subjected to amplitude modulation, the power of the phase modulation RF signal of the constant amplitude is maintained constant. In uncompressed mode, the output power of PA 103 is controlled by maintaining constant the scaling coefficient multiplied upon the envelope of the amplitude path and changing the scaling coefficient multiplied upon the driving signal in the phase path. However, in either operation mode, the scaling coefficient that is not used to control power (in case of compressed mode, the phase path scaling coefficient multiplied upon the phase modulation RF signal and, in case of uncompressed mode, the amplitude path scaling coefficient multiplied upon the amplitude path envelope) does not necessarily need to be maintained constant and may be adjusted to improve distortion characteristics or noise characteristics of a power amplifier output or to correct output power.

Practically, as shown in FIG.7, transmission power controlling section 107 has a scaling coefficient set for compressed mode and a scaling coefficient set for uncompressed mode. With the present embodiment, the scaling coefficient set for compressed mode and the scaling coefficient set for uncompressed mode have an overlap region in the mode transition region.

Transmission power controlling section 107 of the present embodiment will be explained in detail using FIG.7.

In compressed mode, transmission power is controlled by changing the amplitude path scaling coefficient multiplied upon the amplitude path envelope (i.e. amplitude component signal). To be more specific, when PA 103 operates in compressed mode (on the right side of the rightmost vertical dotted line), power control is realized by changing the amplitude path scaling coefficient while maintaining the level of the phase modulation RF signal (that is, while maintaining the phase path scaling coefficient constant).

In uncompressed mode, transmission power is controlled by changing the phase path scaling coefficient multiplied upon the phase modulation RF signal of the phase path. To be more specific, when PA 103 operates in uncompressed mode (on the left side of the leftmost vertical dotted line), power control is realized by changing the phase path scaling coefficient while maintaining constant the amplitude path scaling coefficient multiplied upon the amplitude path envelope (i.e. amplitude component signal). Further, in uncompressed mode, the envelope alone is on the AM path.

The overlap region is where required output power can be generated whichever mode of compressed mode or uncompressed mode is selected. To be more specific, in practice, both compressed mode and uncompressed mode can be realized by providing the amplitude path scaling coefficient and phase path scaling coefficient shown by the solid lines in FIG.7. Additionally, in the present embodiment, the scaling coefficient sets shown by dotted lines are provided in addition to the scaling coefficient sets shown by the solid lines, thereby providing an overlap region where the compressed mode region and the uncompressed mode region are extended to enable PA 103 to operate in either compressed mode or uncompressed mode.

The calibration region refers to an output power range where the mode transition is influenced. To be more specific, the calibration region refers to an output power range where the discontinuity in transmission power is likely to occur upon the mode transition and where calibration is likely to be necessary.

In case of the present embodiment, detecting circuit 106, LPF 108 and ADC 109 of power alignment loop 110 operate only when necessary. To be more specific, according to the TPC command received as input, transmission power controlling section 107 sends out ON/OFF control signals S20 to LPF 108 and ADC 109. For example, as shown in FIG.4, if a TPC command specifies target step size of restrictive tolerance values such as 1 dB, 2 dB, and 3 dB, an ON control signal is outputted as ON/OFF control signal S20. By contrast with this, if a TPC command specifies a target step size of non-restrictive tolerance values such as 4 dB or greater, an OFF control signal is outputted as ON/OFF control signal S20. In this way, power alignment loop 110 can be operated only when necessary in practice, so that it is possible to reduce power consumption.

Transmitting apparatus 100 keeps track of the absolute value of transmission power (PLEV) as represented by, for example, the following equation.

$$[1]$$

$$\mathrm{PLEV}_k = \sum_{k=1}^{N-1} TPC_k + \mathrm{PLEV}_0$$

Here, PLEV is the absolute value of transmission power and TPC is the step size specified by each transmission power command (0, $\pm$1dB, $\pm$2dB or $\pm$3dB in case of FIG.3). Further, $PLEV_0$ is transmission power before power control.

In transmission power controller 107, mode transition thresholds are defined as follows.

When Pc, min is the minimum power level (dBm) that is possible in compressed mode, compressed mode switches to uncompressed mode when $PLEV_k \geq P_{c,min}$ and $PLEV_k + TPC_{k+1} <_{Pc,min}$. Uncompressed mode switches to compressed mode when $PLEV_k < P_{c,min}$ and $PLEV_k + TPC_{k+1} \geq P_{c,min}$.

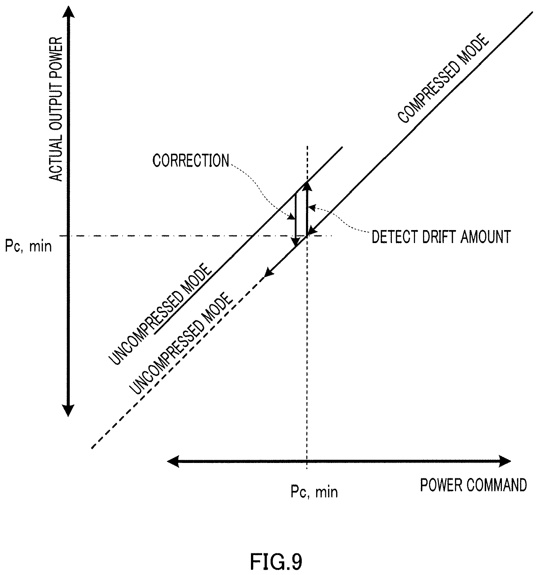

FIG.8 shows a transition operation from compressed mode to uncompressed mode when output power in uncompressed mode at the transition destination is lower than output power in compressed mode at the transition source. FIG.9 shows a transition operation from compressed mode to uncompressed mode when output power in uncompressed mode at the transition destination is higher than output power in compressed mode at the transition source.

In case of FIG. 8 and FIG. 9, transmitting apparatus 100 maintains compressed mode until power Pc,min where capability in compressed mode is the lowest. To obtain the same output power in uncompressed mode as in compressed mode, transmitting apparatus 100 detects how much uncompressed mode has drifted from the original power calibration value (i.e. drift amount). Transmitting apparatus 100 detects this drift amount utilizing PAL 110. Then, to remove drift in uncompressed mode, in other words, to suppress the discontinuity between compressed mode and uncompressed mode, transmitting apparatus 100 corrects power parameters (i.e. scaling coefficients S10 and S11) in uncompressed mode.

In this way, in FIG.8 and FIG.9, even in cases where, if correction is not performed, transition to the output power line in uncompressed mode shown by the solid line increases the discontinuity in output power, transition to the output power line in uncompressed mode shown by the dotted line takes place by performing the correction, so that the discontinuity in output power upon transition from compressed mode to uncompressed mode is suppressed.

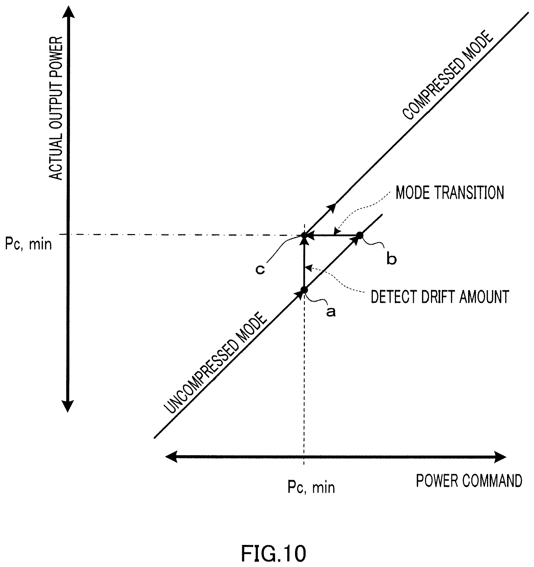

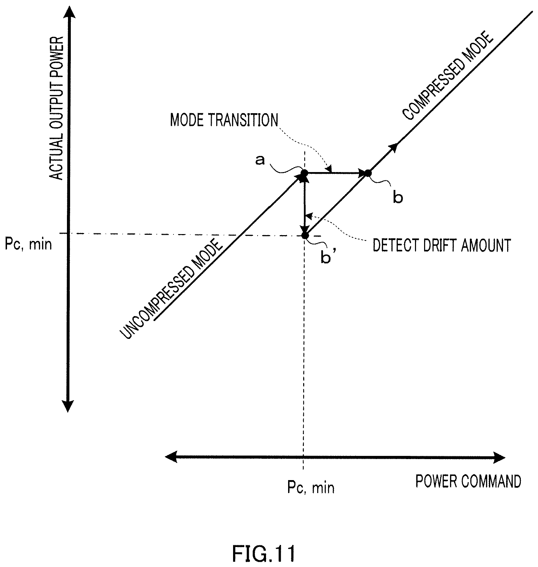

FIG. 10 and FIG. 11 show transition operations from uncompressed mode to compressed mode. FIG.10 shows a transition operation when output power in uncompressed mode at the transition source is lower than output power in compressed mode at the transition destination. Further, FIG.11 shows a transition operation when output power in uncompressed mode at the transition source is lower than output power in compressed mode at the transition destination.

The transition operation in FIG.10 will be explained. When the output power command reaches minimum power level Pc,min that is possible in compressed mode in operation point a in uncompressed mode, transmitting apparatus 100 measures actual output power by operating detecting circuit 106, LPF 108 and ADC 109 and detects the difference between actual output power and Pc,min as the drift amount in uncompressed mode. Transmission power controlling section 107 increases output power to operation point b in which the actual output power level becomes Pc,min, based on this drift amount while maintaining uncompressed mode. When output power reaches operation point b in uncompressed mode, transmitting apparatus 100 makes mode transition to operation point c in compressed mode and then starts operating in compressed mode. In this way, when the output power command reaches minimum power level Pc,min that is possible in compressed mode (that is, when the output power command reaches operation point a), transition is made to operation point c via operation point b, instead of making transition directly to operation point c in compressed mode, so that mode transition from operation point b to operation point c is possible in a state where drift in output power is little.

The transition operation of FIG.11 will be explained. When the output power command reaches minimum power level Pc,min that is possible in compressed mode in operation point a in uncompressed mode, transmitting apparatus 100 measures the actual output power by operating detecting circuit 106, LPF 108 and ADC 109 and detects the difference between the actual output power and Pc,min, as the drift amount in uncompressed mode. Transmission power controlling section 107 finds scaling coefficients S10 and S11 in compressed mode that can acquire the output power level equivalent to output power in operation point a, based on this drift amount (or the actual output power in operation point a) and outputs scaling coefficients S10 and S11, thereby making transition to operation point b in compressed mode. In this way, when the output power command reaches minimum power level Pc,min that is possible in compressed mode (that is, when the output power command reaches operation point a), transition is made to operation point b in compres sedmode in which output power equivalent to output power in operation point a can be acquired instead of making transition to operation point b' of Pc,min in compressed mode, so that mode transition from operation point a to operation point b is possible in a state where drift in output power is little.

That is, as shown in FIG.10 and FIG.11, horizontal transitions (i.e. the transition from operation point b to operation point c in FIG.10 and the transition from operation point a to operation point b in FIG.11) are performed such that the actual output power from transmitting apparatus 100 is maintained. When the TPC command is equivalent to transition power of the target from uncompressed mode to compressed mode, transmitting apparatus 100 measures the drift amount in uncompressed mode. As shown in FIG.10, if drift takes place downward, transmitting apparatus 100 maintains uncompressed mode until power in uncompressed mode reaches the overlap region and transitions to compressed mode when reaching the overlap region. As shown in FIG.11, if drift takes place upward, transmitting apparatus 100 transitions to compressed mode while maintaining output power by looking up the power table.

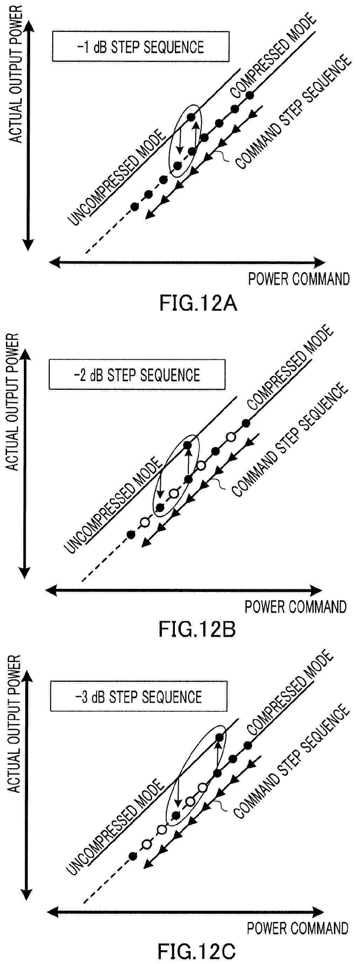

FIG.12A, FIG.12B and FIG.12C each show a transition operation from compressedmode to uncompressed mode when output power in uncompressed mode at the transition destination is higher than output power in compressed mode at the transition source. FIG.12A shows a simple case where output power is reduced by -1 dB at a time. FIG.12B shows a case where output power is reduced by -2 dB at a time. FIG.12C shows a case where output power is reduced by -3 dB at a time.

FIG.12A, FIG.12B and FIG.12C basically show the same operation as in FIG. 9. That is, even in cases where, if correction is not performed, transition to the output power line in uncompressed mode shown by the solid line increases the discontinuity in output power, transition is made to the output power line in uncompressed mode shown by the dotted line by performing the correction, so that the discontinuity in output power upon transition from compressed mode to uncompressed mode is suppressed.

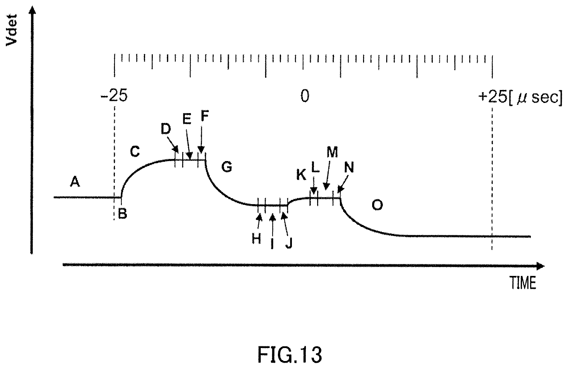

FIG.13 shows how transmitting apparatus 100 transitions from compressed mode to uncompressed mode when output power in uncompressed mode at the transition destination is higher than output power in compressed mode at the transition source.

FIG.13 shows an example of a transition state in operation mode in case where transmission is performed according to the W-CDMA standard. As is obvious to one of ordinary skill in the art, with W-CDMA, the output of the power amplifier is changed to a specified output power level between symbols.

FIG.13 assumes that the boundary between these symbols is 0 microsecond. Further, according to the 3GPP specification, in a period of $\pm 25$ microseconds before and after the symbol boundary, the output power level of the power amplifier is not specified and therefore needs not to be within the range of a tolerance value with respect to the set power.

Accordingly, in transmitting apparatus 100 according to the present embodiment, in a period of 25 microseconds before and after the symbol boundary, operation mode switches between compressed mode and uncompressed mode and the output power levels of the power amplifier in both operation modes are checked and the operation of switching operation mode is performed based on the check result.

Transmitting apparatus 100 carries out the following operations at points (A) to (O) shown in FIG.13. Here, Vdet is the output of detecting circuit 106.

(A) Measure output voltage Vdet of detecting circuit 106 in compressed mode
(B) Switch mode to uncompressed mode with same output power
(C) Wait for Vdet to settle
(D) Load Vdet in uncompressed mode in transmission power controlling section 107
(E) Calculate a power correction value in uncompressed mode based on the difference between Vdet in (A) and Vdet in (D)
(F) Control uncompressed mode by setting the phase path scaling coefficient (further, the amplitude path scaling coefficient may be changed) based on the correction value determined in (E) such that output power in uncompressed mode becomes equal (or close) to output power in compressed mode
(G) Wait for Vdet to settle
(H) Load new Vdet in transmission power controlling section 107
(I) Calculate a more accurate power correction value in uncompressed mode based on the difference between Vdet in (A) and Vdet in (H)
(J) Control uncompressed mode by setting the phase path scaling coefficient (further, the amplitude path scaling coefficient may be changed) based on the correction value updated in (I) such that output power in uncompressed mode becomes equal (or close) to output power in compressed mode
(K) Wait for Vdet to settle
(L) Load new Vdet in transmission power controlling section 107
(M) Calculate the final power correction value in uncompressed mode based on the difference between Vdet in (A) and Vdet in (L)
(N) Update uncompressed mode by setting the phase path scaling coefficient (further, the amplitude path scaling coefficient may be changed) based on the correction value in (M) such that output power in uncompressed mode becomes equal (or close) to output power in compressed mode, and proceed to a new TPC step
(O) Execute the TPC step

Further, the final correction value is used while transmission apparatus 100 maintains uncompressed mode.

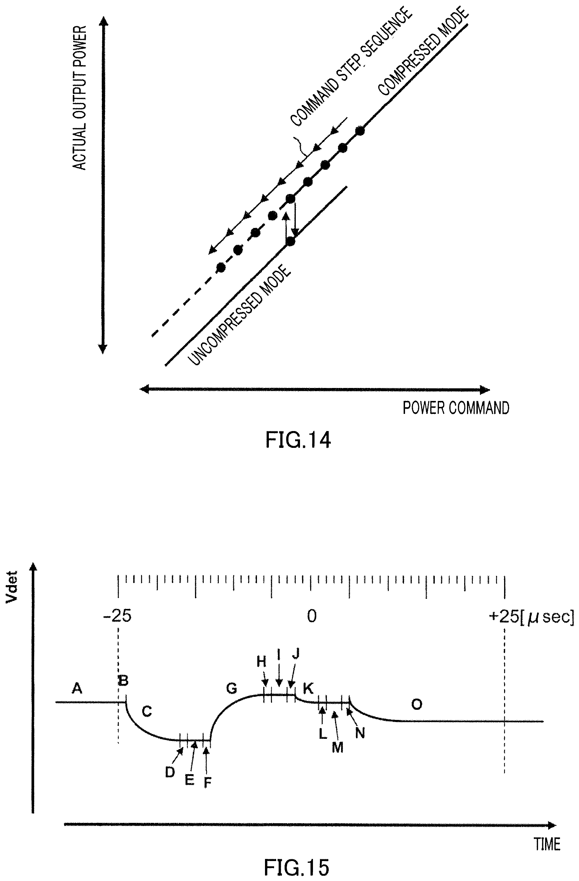

FIG.14 shows a transition operation from compressed mode to uncompressed mode when output power in uncompressed mode at the transition destination is smaller than output power in compressed mode at the transition source. FIG.14 shows a simple case where output power is decreased by -1 dB at a time. FIG.14 basically shows the same operation as in FIG.8. That is, even in cases where, if correction is not performed, transition to the output power line in uncompressed mode shown by the solid line increases the discontinuity in output power, transition is made to the output power line in uncompressed mode shown by the dotted line by performing the correction, so that the discontinuity in output power upon transition from compressed mode to uncompressed mode is suppressed.

FIG.15 shows in detail how the transmitting apparatus transitions from compressed mode to uncompressed mode when output power in uncompressed mode at the transition destination is lower than output power in compressed mode at the transition source. Further, explanation of the time domain in FIG.15 is the same as in FIG.13.

Transmitting apparatus 100 carries out the following operations at points (A) to (O) shown in FIG. 15.

(A) Measure output voltage Vdet of detecting circuit 106 in compressed mode
(B) Switch mode to uncompressed mode with the same output power command
(C) Wait for Vdet to settle
(D) Load Vdet in uncompressed mode in transmission power controlling section 107
(E) Calculate the first power correction value in uncompressed mode based on the difference between Vdet in (A) and Vdet in (D)
(F) Control uncompressed mode by setting the phase path scaling coefficient (further, the amplitude path scaling coefficient may be changed) based on the correction value determined in (E) such that output power in uncompressed mode becomes equal (or close) to output power in compressed mode
(G) Wait for Vdet to settle
(H) Load new Vdet in transmission power controlling section 107
(I) Calculate a more accurate power correction value in uncompressed mode based on the difference between Vdet in (A) and Vdet in (H)
(J) Control uncompressed mode by setting the phase path scaling coefficient (further, the amplitude path scaling coefficient may be changed) based on the correction value updated in (I) such that output power in uncompressed mode becomes equal (or close) to output power in compressed mode
(K) Wait for Vdet to settle
(L) Load new Vdet in transmission power controlling section 107
(M) Calculate the final power correction value in uncompressed mode based on the difference between Vdet in (A) and Vdet in (L)
(N) Update uncompressed mode by setting the phase path scaling coefficient (further, the amplitude path scaling coefficient may be changed) based on the correction value in (M) such that output power in uncompressed mode becomes equal (or close) to output power in compressed mode, and proceed to a new TPC step
(O) Execute the TPC step

Next, a case will be explained where uncompressed mode transitions to compressed mode.

First, the +1 dB step will be explained.

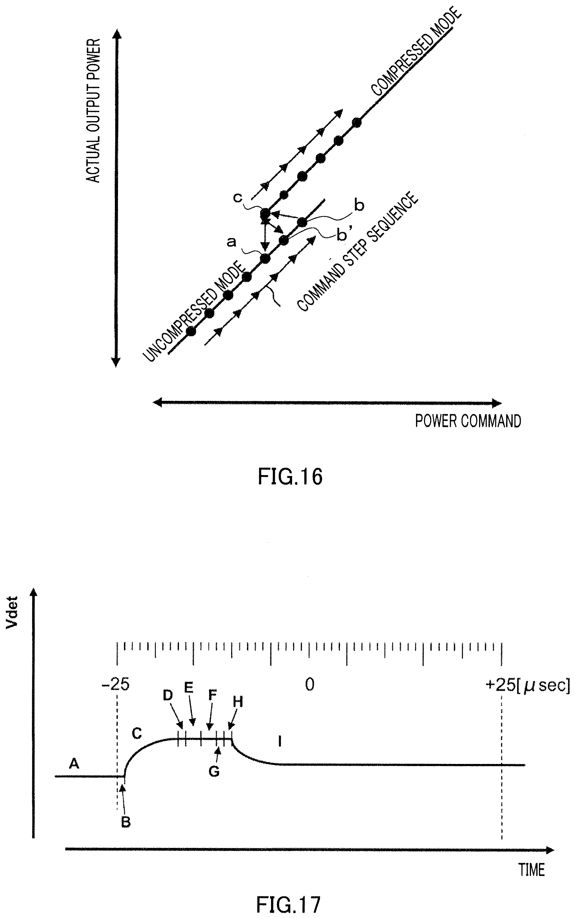

FIG.16 shows the transition operation from uncompressed mode to compressed mode when output power in uncompressed mode at the transition source is lower than output power in compressed mode at the transition destination. FIG.16 shows a simple case where transmission power is increased by +1dB at a time.

FIG.16 basically shows the same operation as in FIG.10. In this way, when the output power command reaches minimum power level Pc,min that is possible in compressed mode (that is, when the output power command reaches operation point a), transition is made to operation point c via operation points b' and b instead of making transition directly to operation point c in compressed mode, so that mode transition from operation point b to operation point c is possible in a state where drift in output power is little.

FIG.17 shows in detail how transmitting apparatus 100 transitions from uncompressed mode to compressed mode when output power in uncompressed mode at the transition source is lower than output power in compressed mode at the transition destination. FIG.17 shows, for example, the operation upon transition from operation point b to operation point c in FIG.16. Further, explanation of the time domain in FIG.17 is the same as in FIG.13.

Transmitting apparatus 100 carries out the following operations at points (A) to (I) shown in FIG.17.

(A) Measure output voltage Vdet of detecting circuit 106 in uncompressed mode
(B) Switch mode to compressed mode with the same output power command
(C) Wait for Vdet to settle
(D) Load Vdet in compressed mode in transmission power controlling section 107
(E) Calculate the power difference with respect to uncompressed mode based on the difference between Vdet in (A) and Vdet in (D)
(F) Select the address (see table 1) from the scaling coefficient set in compressed mode in the power table that minimizes the power difference in (E)
(G) Change the scaling coefficient set associated with the address selected in (F), according to the TPC command
(H) Control compressed mode using the scaling coefficient changed in (G)
(I) Execute the TPC step

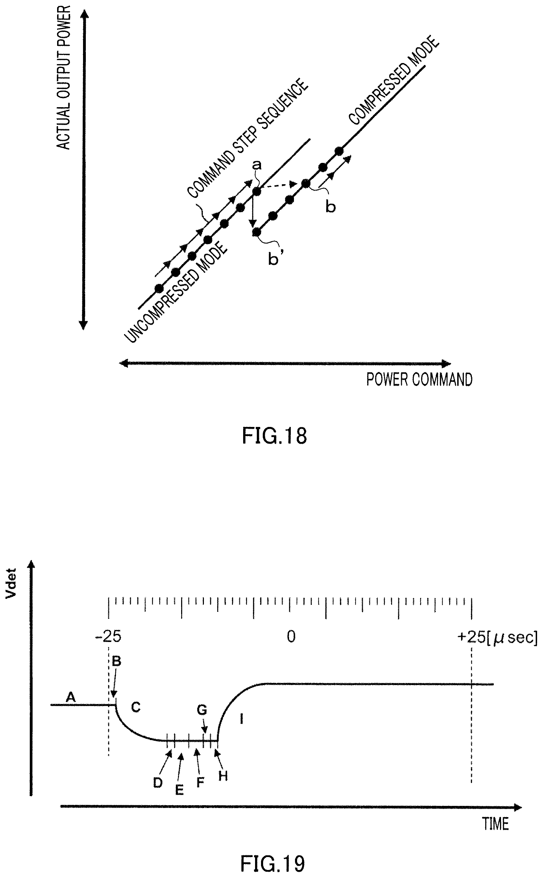

FIG.18 shows the transition operation from uncompressed mode to compressed mode when output power in uncompressed mode at the transition source is higher than output power in compressed mode at the transition destination. FIG.18 shows a simple case where transmission power is increased +1 dB at a time.

FIG.18 basically shows the same operation as in FIG.11. That is, when the output power command reaches minimum power level Pc, min that is possible in compressed mode (that is, when the output power command reaches operation point a), transition is made to operation point b in which output power equal to output power in operation point a can be acquired, instead of making transition to operation point b' of Pc,min in compressed mode, so that mode transition from operation point a to operation point b is possible in a state where drift in output power is little.

FIG.19 shows in detail how transmitting apparatus 100 transitions from uncompressed mode to compressed mode when output power in uncompressed mode at the transition source is higher than output power in compressed mode at the transition destination. FIG.19 shows the operation upon transition from, for example, operation point a to operation point b in FIG.18. Further, explanation of the time domain in FIG.19 is the same as in FIG.13.

Transmitting apparatus 100 carries out the following operations at points (A) to (I) shown in FIG.19.

(A) Measure output voltage Vdet of detecting circuit 106 in uncompressed mode
(B) Switch mode to compressed mode with the same output power command
(C) Wait for Vdet to settle
(D) Load Vdet in compressed mode in transmission power controlling section 107
(E) Calculate the power difference with respect to uncompressed mode based on the difference between Vdet in (A) and Vdet in (D)
(F) Select the address (see table 1) from the scaling coefficient set in compressed mode in the power table that minimizes the power difference in (E)
(G) Change the scaling coefficient set associated with the address selected in (F), according to the TPC command
(H) Control compressed mode using the scaling coefficient changed in (G)
(I) Execute the TPC step

Further, transition to compressed mode employing the step size of 4 dB or more does not require the power adjusting operation by power alignment loop 110. This is because the tolerance with respect to the 4 dB power step is $\pm 2.0$ dB, which can be achieved without the power adjusting operation by power alignment loop 110. In addition, temperature compensation can be applied, if it is necessary to increase the margin to $\pm 2.0$ dB according to the specification.

Likewise, transition to uncompressed mode employing the step size of 4 dB or more does not require power adjustment by power alignment loop 110. Larger step sizes have larger error tolerance values. The largest error tolerance value $\pm 6.0$ dB is beyond the total drift amount in uncompressed mode.

In this way, with the present embodiment, when the TPC command showing a step size equal to or greater than a predetermined value, power is not adjusted by power alignment loop 110, so that it is possible to reduce unnecessary power consumption.

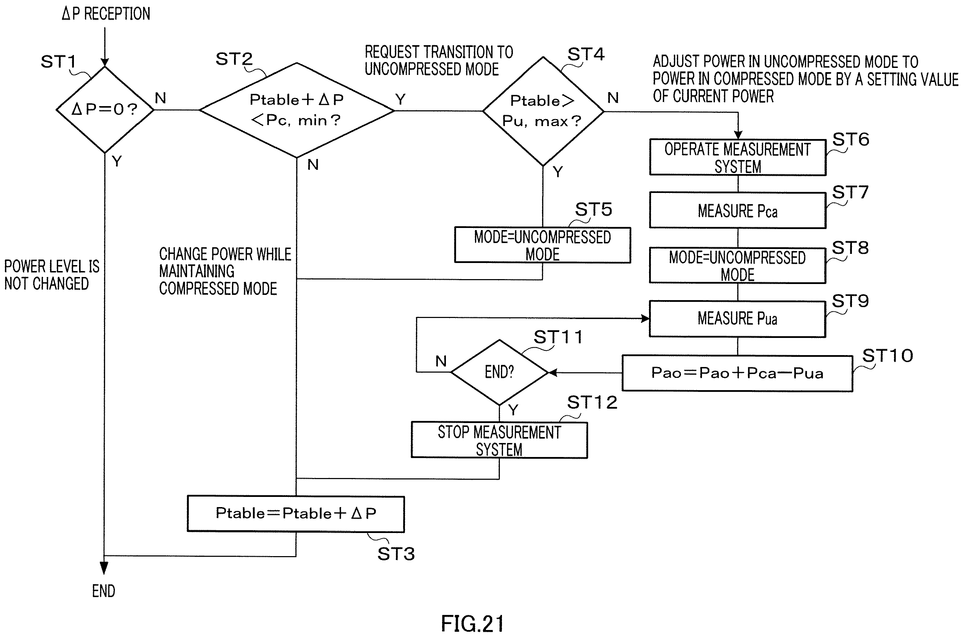

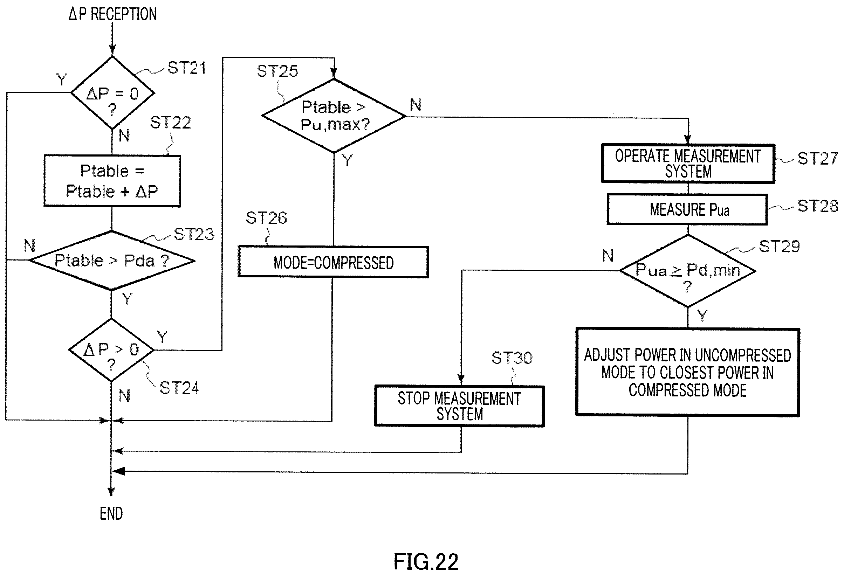

Next, the overall operation of transmitting apparatus 100 of the present embodiment will be explained using the flowcharts of FIG.21 and FIG.22.

First, the parameters used in the flowcharts will be explained.

Pao: The gain offset (dB) in variable gain amplifier 105 for power alignment loop 110 and is applicable only in uncompressed mode.
Ptable: The output power level setting value (dBm) stored in the power table.
Pca: Actual power (dBm) in compressed mode measured through detecting circuit 106.
Pua: Actual power (dBm) in uncompressed mode measured through detecting circuit 106.

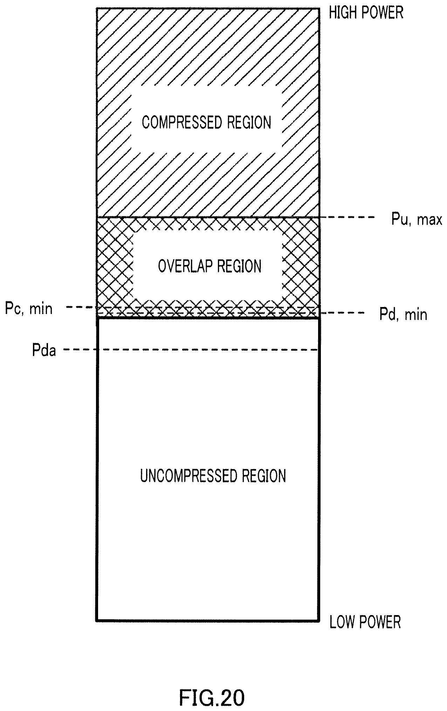

In addition, the parameters in FIG.20 employ the following definitions:

Pc,min: Minimum value of power (dBm) in compressed mode.
Pn,max: Maximumvalue of power (dBm) in uncompressed mode.
Pda: The power threshold (dBm) in detecting circuit 106 in operation, and this is the minimum tolerance value in uncompressed mode and the power level that can be actually produced in the overlap region.
Pd,min: The minimum value (dBm) that can be actually measured in case of the power level Pc,min and that represents the smallest registered value associated with Pc,min due to the defect in detecting circuit 106.

With the present embodiment, PA 103 of transmitting apparatus 100 is configured to operate in compressed mode in a period transmission power is greater than the first threshold, and to operate in uncompressed mode in a period transmission power is smaller than the second threshold.

FIG.20 explicitly shows a compressed operation region and an uncompressed operation region. Pu,max is associated with the first threshold and Pc,min is associated with the second threshold. As described above, the overlap region refers to a power level region in which the same output power is possible in either compressed mode or uncompressed mode. The boundaries of the overlap region may be programmed. By means of programming, transmitting apparatus 100 is adaptable to various operations of the wireless communication system, and, further, can accommodate a set of a plurality of power amplifiers having different dynamic characteristics.

FIG.21 is a flowchart explaining the operation in compressed mode.

When transmitting apparatus 100 receives a new transmission power control signal including information about the change level $\Delta P$ in transmission power (for example, TPC command), in step ST1, transmission power controlling section 107 detects the power change level $\Delta P$ specified by the transmission power control signal (i.e. TPC command), and the flow ends if there is no change or proceeds to step ST 2 if there is a change. In step ST 2, if the value to which the change level $\Delta P$ is added by transmission power controlling section 107 is equal to or greater than the minimum value Pc,min in the overlap region (ST 2: "No"), transmission power controlling section 107 determines that compressed mode is possible and the flow proceeds to step ST 3 to change power by $\Delta P$. On the other hand, if the value to which the change level $\Delta P$ is added in step ST 2 is less than the minimum value Pc,min in the overlap region (ST 2: "Yes"), transmission power controlling section 107 determines that transition to uncompressed mode is necessary, and the flow proceeds to step ST 4.

If a positive result is obtained in step ST 4, this means that power changes so significantly that power alignment loop 110 is not necessary. In this case, the flow proceeds to step ST 5 to simply transition mode to uncompressed mode, and then proceeds to step ST 3. On the other hand, if a negative result is obtained in step ST 4, transmission power controlling section 107 determines that the power alignment loop operation is necessary, and the flow proceeds to step ST 6.

Transmitting apparatus 100 starts operations of the measurement system, that is, detecting circuit 106, LPF 108 and ADC 109 of power alignment loop 110 in step ST 6, measures output power Pca of PA 103 in compressed mode in step ST 7, changes mode to uncompressed mode in step ST 8, and measures output power Pua of PA 103 in uncompressed mode in step ST 9. Transmission power controlling section 107 carries out error correction in step ST 10, checks whether or not error correction is finished in step ST 11, and, if error correction is finished, stops the operations of the measurement system, that is, detecting circuit 106, LPF 108 and ADC 109 in power alignment loop 110 in step ST 12, and the flow proceeds to step ST 3. Other than the above, steps ST 9 and ST 10 are repeated. Further, checking whether or not error correction is finished in step ST 11 may be performed based on, for example, whether or not the difference (Pca-Pua) falls within a certain range or based on whether or not the number of times to repeat steps ST 9 and ST 10 reaches the specified value.

FIG.22 is a flowchart explaining the operation in case where transmitting apparatus 100 is placed in uncompressed mode at first.

When transmitting apparatus 100 receives a new transmission power control signal including information about the change level $\Delta P$ in transmission power (for example, TPC command), transmission power controlling section 107 detects the change level $\Delta P$ specified by the transmission power control signal (i.e. TPC command) in step ST 21, and the flow ends if there is no change (that is, the operation at the current power level continues in uncompressed mode and this flow stops until a TPC command for changing the power level is received) or proceeds to step ST 22, if there is a change, to change power by $\Delta P$ (that is, Ptable = Ptable + $\Delta P$ holds).

In step ST 23, transmission power controlling section 107 determines whether or not the newly set power table is within the region in uncompressed mode. This operation is carried out by comparing Ptable + $\Delta P$ and Pda and deciding whether or not Ptable + $\Delta P$ is greater than Pda. As described above, Pda corresponds to the minimum power level in uncompressed mode for satisfying the tolerance value. If it is decided that Ptable + $\Delta P$ is not greater than Pda, the flow ends and transmitting apparatus 100 continues the uncompressed mode operation. On the other hand, if it is decided that Ptable + $\Delta P$ is greater than Pda (that is, if the power table is within the uncompressed mode region), the flow proceeds to step ST 24. In step ST 24, it is decided whether or not the change level $\Delta P$ increases. If a positive result is obtained in both steps ST 23 and ST 24, this means that the specified power does not fall within the uncompressed mode region, and so the flow proceeds to step ST 25. Otherwise, the flow ends and transmitting apparatus 100 continues the operation in uncompressed mode.

In step ST 25, it is decided whether or not Ptable + $\Delta P$ is greater than the maximum possible power level Pu,max in uncompressed mode. If a positive result is obtained in step ST 25, this means that power changes so significantly that the power alignment loop operation is not necessary, and, in this case, transmission power controlling section 107 proceeds to step ST 26 to simply transition mode to compressed mode. On the other hand, if a negative result is obtained in step ST 25, transmission power controlling section 107 decides that the power alignment loop operation is necessary, and the flow proceeds to step ST 27.

Transmitting apparatus 100 starts the operations of the measurement system, that is, detecting circuit 106, LPF 108 and ADC 109 in power alignment loop 110, in step ST 27, and measures output power Pua of PA 103 in uncompressed mode in step ST 28. In step 29, transmitting apparatus 100 checks whether or not output power Pua in uncompressed mode that has been actually measured has reached the overlap region, and, if it has not, stops the operations of the measurement system, that is, detecting circuit 106, LPF 108 and ADC 109 in power alignment loop 110, in step ST 30, and operates in uncompressed mode with new power level setting and the flow ends.

On the other hand, when transmitting apparatus 100 confirms that output power in uncompressed mode has reached the overlap region (in case where it is decided that Pua≥Pd,min), the flow proceeds to step ST 31 and adjusts power in uncompressed mode to the closest power in compressed mode.

As described above, according to the present embodiment, when the transmitting apparatus operates in two power amplifier operation modes where the first operation mode (i.e. compressed mode) is fundamentally accurate and the second operation mode (i.e. uncompressed mode) is fundamentally less accurate, the measurement value of the power amplifier output in the first operation mode is used to correct the power amplifier output in the second operation mode, so that it is possible to suppress drift in transmission power (i.e. discontinuity in output power) due to the mode switch even when the fundamentally accurate first operation mode and the fundamentally less accurate second operation mode switch.

Furthermore, according to the present embodiment, the transmitting apparatus provides a scaling coefficient set for the first operation mode and a scaling coefficient set for the second operation mode having an overlap region in the power boundary between the first operation mode (i.e. compressedmode) and the second operation mode (i.e. uncompres sedmode), and controls transmission power using these scaling coefficient sets, so that it is possible to suppress drift in transmission power (i.e. discontinuity in output power) due to the mode switch even when the fundamentally accurate first operation mode and the fundamentally less accurate second operation mode switch.

Further, according to the present embodiment, the transmitting apparatus selects one of the first mode switch for switching mode between compressed mode and uncompressed mode with reference to the output power level of PA 103 and the second mode switch for switching mode between compressed mode and uncompressed mode without reference to the output power level of PA 103, and, consequently, measuring sections such as detecting circuit 106, LPF 108 and ADC 109 can be operated when necessary in practice, so that it is possible to suppress drift in transmission power (i.e. discontinuity in output power) due to the mode switch at low power consumption.

(Embodiment 2)

With the present embodiment, a method and apparatus that are based on the method and apparatus of Embodiment 1 and, in addition, that can meet the demand for power control accuracy as shown in, for example, FIG.4, are presented.

Whether PA 103 is operated in compressed mode or uncompressed mode depends on applications. According to an exemplary embodiment adapted for W-CDMA, the lowest power level (Pc,min) in compressed mode is specified as 0 dBm and the overlap region is 6 dB wide (an additional margin of 2dB is added to +/- 2 dB).

Upon the operation, transmitting apparatus 100 is commanded to increase and decrease its output power to match network operating environment. For example, as discussed above, in UMTS applications, TPC commands require transmitting apparatus 100 to increase or decrease output power in units of +/- 1 dB, +/- 2 dB and the like). As described above, when a current power level within the uncompressed mode region increases by a power level step ($\Delta P$), if an output power level is still within the uncompressed mode region, transmitting apparatus 100 simply reads an appropriate amplitude path scaling coefficient and/or phase path scaling coefficient from a power table and registers them as an address into the table using the new power level. Transmission power controlling section 107 then applies the scaling coefficients to amplitude controlling circuit 104 and variable amplifying circuit 105 to change the power level.

If the power level increases significantly to jump beyond the overlap region (for example, from the uncompressed region and the compressed region), mode is switched by reading the appropriate amplitude and phase scaling coefficients for setting PA 103 in new mode at the new power level. Because tolerance values for the output power level are wide for these large step sizes, calibration between two modes is not required.

The condition is different when smaller step width is commanded, and, when the power level increases by $\Delta P$, the output power level falls within the overlap region. When this condition occurs, power alignment loop 110 of transmitting apparatus 100 is activated to determine whether a mode switch from uncompressed mode to compressed mode is required, and to determine what steps must be taken to ensure that the resulting, changed power level satisfies specified tolerance values for output power level control.

As explained above, the discontinuity or gap is observed between the output power level curve in compressed mode and the output power level curve in uncompressed mode, due to the difference in dynamic characteristics of an electrical circuit element in the phase path of transmitting apparatus 100. Unfortunately, there are cases where this discontinuity makes it difficult to satisfy power control tolerance values when mode switches at the power level in the overlap region. For example, the W-CDMA standard allows a tolerance value of +/- 0.5 dB for 1 dB power step sizes.

According to the present embodiment, power alignment loop 110 is activated to ensure that, when a power level falls within the overlap region, power control tolerance values specified according to a wireless standard are met. To be more specific, when the changed power level falls within the overlap region, power alignment loop 110 of transmitting apparatus 100 executes an algorithm for determining the scaling coefficients required by amplitude controlling circuit 104 and variable gain amplifier 105 to provide the target output power level. The algorithm may be implemented in one or more integrated circuits according to a predetermined rule. The integrated circuit may be separate from transmitting apparatus 100 or include some or all of the other components of transmitting apparatus 100. The actual scaling coefficients and/or correction coefficients are stored in a table and can be looked up based on a power control signal (i.e. TPC command) received in transmission power controlling section 107.

When transmission power controlling section 107 increases the output power level from the uncompressed mode region to the compressed mode region based on the power level step $\Delta P$ specified by a TPC command, the algorithm of power alignment loop 110 operates to determine the closest power level in compressed mode that satisfies the specification of power control accuracy according to the applicable wireless standard, while maintaining the same settings as in variable gain amplifier 105. However, additional power level entries are necessary in the power table to perform accurate power control meeting the requirements.

A case will be explained below assuming that all setting errors in power setting are equal. A case will be studied here where, for example, transmitting apparatus 100 of a W-CDMA system is commanded to change the output power level by $\Delta P = 1$ dB at a time, the current output power level, Ptable, is tentatively set at a nominal level of -1 dBm and the lowest power level in compressed mode is 0 dBm. Because a power control tolerance value of +/- 0.5 dB is allowed for $\Delta P = 1$ dB, this means that the output power level before the power level change may be within a range between -1.25 and -0.75 dBm.

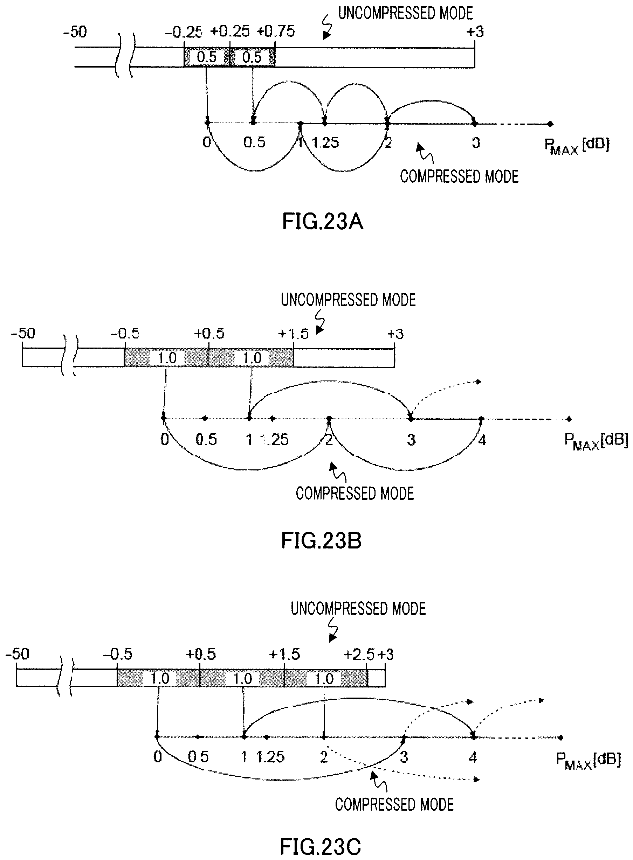

The $\Delta P = 1$ dB increase in the power level leads to an output power level of Ptable + $\Delta P$ within the range between -0.25 and +0.25 dBm, as shown in the mode transition diagram of FIG.23A. A mode switch to compressed mode which is available and the closest to the power level of 0 dBm, satisfies the power accuracy tolerance value of +/- 0.5 dB allowed by the W-CDMA specification and even satisfies a more restrictive tolerance step size of the maximum difference of +/- 0.25 dB.

Unfortunately, a tolerance step size of the maximum difference of +/- 0.25 dB cannot be satisfied in all power level transitions from uncompressed mode to compressed mode. Assume, for example, that the current power level in uncompressed mode, Ptable, is -0.7 dBm.

A $\Delta P = + 1$ dB power level step leads to a uncompressed mode power level of 0.3 dBm and a tolerance range of 0.3 +/- 0.5 dBm (that is, -0.2 dBm to 0.8 dBm). With the tolerance step size of the maximum difference of +/- 0.25 dB (i.e. +/- 0.5 dB in the present specification), a transition to compressed mode closest to the power level of 1 dBm would provide power in the range of 1 +/- 0.25 dBm (that is, 0.75 dBm to + 1.25 dBm).

Such a mode transition makes the upper end value of the power level range greater than the upper tolerance level in the tolerance range between -0.2 dBm and 0.8 dBm. Therefore, the power control tolerance value of the W-CDMA specification is violated if a mode switch to the compressed mode at the power level of 1 dBm is allowed. A transition to the compressed mode power level of 0 dB (0 +/- 0.25 dBm or -0.25 dBm to +0.25 dBm) makes the lower end value of the power level range less than the lower tolerance level in the tolerance range between -0.2 dBm and 0.8 dBm, thereby violating the specification.

According to the present embodiment, extra compressed mode power levels are added to the power table, and made available for switching mode from uncompressed mode to compressed mode. Consequently, it is possible to satisfy the power control accuracies specified by the wireless standard in use.

For example, it is possible to meet the requirement for power control accuracy of +/- 0.5 dB upon the 1 dB step size in the W-CDMA standard by adding power of 0.5 dBm to compressed mode power and storing compressed mode power in a power table.

Compliance with the W-CDMA specification can be checked by considering the above example, where a command for increasing power by 1 dB is received and a mode switches from 0.3 dBm in uncompressed mode to 0.5 dBm in compressed mode. As can be seen, the upper and lower power levels in the power level range (0.5 dBm +/- 0.25 dB) are both within the tolerance range between -0.2 dBm to 0.8 dBm. Compliance with the specification at other power levels can be checked, as is readily appreciated by one of ordinary skill in the art.

Additional power level values may be added to the power table in compressed mode to satisfy the cumulative tolerance values (see FIG.5) in a reliable manner. For example, as shown in FIG.23A, when the level of 1.25 dB is included, the power level command moves from 0.5 dBm, then to 1.25 dBm, 2 dBm, and so on, according to the power command of subsequent 1 dB to 1.25 dB.

For larger power level step sizes, additional power table entries (0.25 dBm and 1.25 dBm in the example above) do not need to be entered in the power table. This is because the power control tolerance values for larger step sizes are less restrictive.

FIG's.23B and 23C show, for example, mode transitions from uncompressed mode to compressed mode when transmitting apparatus 100 is commanded to increase the output power level by $\Delta P = 2$ dB and $\Delta P = 3$ dB. The power control tolerance values for a 2 dB step size are +/- 1 dB (see the table in FIG. 3), and are +/- 2 dB for a 3 dB step size, and both of these tolerance values are wide enough to allow transitions to existing power levels in compressed mode while accommodating a maximum step size difference of +/- 0.5 dB.

FIG's.24A and 24B are flowcharts explaining the operations when transmitting apparatus 100 first enters uncompressed mode. Further, the processings in steps ST 21 to ST 30 have already been explained in FIG.22, and therefore processings after step ST 31 will be explained.

If it is concluded that Ptable + $\Delta P$ falls within the overlap region in step ST 29 (ST 29: YES), the power alignment loop algorithm decides whether or not the new power level Ptable + $\Delta P$ falls within the shaded region in FIG's. 23A, 23B or 23C to decide whether a mode switch from uncompressed mode to compressed mode is required. To make this decision, transmission power controlling section 107 of transmitting apparatus 100 places PA 103 in compressed mode to operate at the lowest possible output power level that can be used in compressed mode, as shown in steps ST 31 and ST 32.

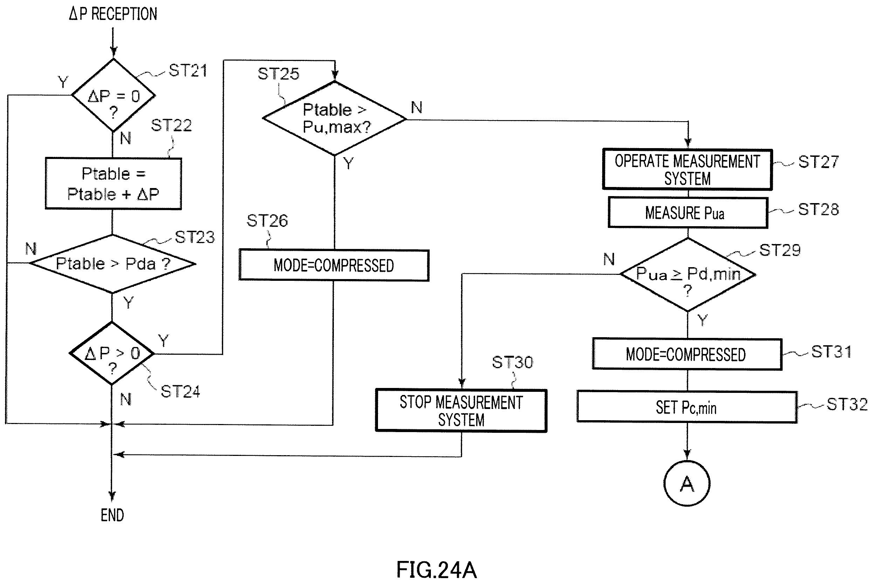

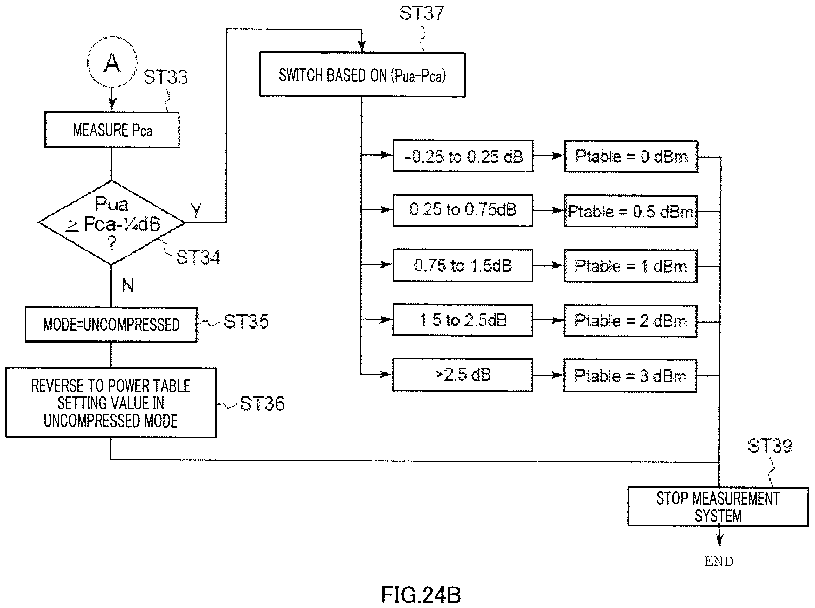

Then, at step ST 33 (see FIG.24B), the actual output in compressed mode Pca is measured by detecting circuit 106 and compared to the actual output power measured in step ST28. Next, in step ST34, the power alignment algorithm determines whether Pca - Pua is equal to or less than 0.25 dB. If Pca - Pua is equal to or less than 0.25 dB, this means that the power level has not reached the overlap region yet, and no power alignment (i.e. calibration) between the power level in uncompressed mode and the power level in compressed mode is required. The difference in the power level curve in uncompressed mode is sufficiently small, so that power in the power level in compressed mode needs not to be adjusted, and the pre-calibrated power table entries can be used as is. In this case, mode is transitioned to uncompressed mode in step ST 35, and the scaling coefficient set read from the power table in ST 36 is changed to the scaling coefficient in uncompressed mode.

However, if Pca - Pua is greater than 0.25 dB, the drift is significant and, therefore, power needs to be adjusted to the closest compressed mode power level. This is realized by switching mode to compressed mode in step ST 37 and selecting the appropriate power table entry in compressed mode, based on the difference between Pua and Pca. If the overlap region changes due to device characteristic, the values in the "switch" state also changes reflecting the new overlap region. Once the calibration is completed, the operation of the measurement system in power alignment loop 110 stops in step ST 39 and then transmitting apparatus 100 continues operating at the compressed mode power level until a new power level change command is received.

Industrial Applicability

The present invention is preferably applicable to, for example, a polar modulation transmitting apparatus.

**Claims**

1. A transmitting method in a communication transmitting apparatus supporting two power amplifier operation modes of a compressed mode and an uncompressed mode, the transmitting method comprising:

   a measuring step of measuring an output power level of a power amplifier (103);
   a first mode switching step of switching between the compressed mode and the uncompressed mode with reference to the output power level of the power amplifier (103);
   a second mode switching step of switching between the compressed mode and the uncompressed mode without reference to the output power level of the power amplifier(103); and
   a selecting step of selecting between performing the first mode switching step and performing the second mode switching step.

2. The transmitting method according to claim 1, wherein the selecting step selects between performing the first mode switching step and performing the second mode switching step based on a transmission power control signal including information about a change level in transmission power.

3. The transmitting method according to claim 1, further comprising a defining step of defining an overlap power level region in which the power amplifier (103) outputs power at substantially equal output power levels in both operation modes of the compressed mode and the uncompressed mode.

4. The transmitting method according to claim 3, wherein the selecting step selects between performing the first mode switching step and performing the second mode switching step based on whether a power level is within the overlap power level region.

5. The transmitting method according to claim 3, wherein the first and second mode switching steps comprise a determining step of determining the operation mode of the power amplifier (103) between the compressed mode and the uncompressed mode when the power amplifier (103) decides that the power level falls within a range of the overlap power level region, based on a transmission power control signal including information about a change level in transmission power.

6. The transmitting method according to claim 5, further comprising a referring step of referring to a power table recording a target output power level in advance when the power amplifier (103) is operated in the determined operation mode.

7. The transmitting method according to claim 1, wherein the selecting step further comprises a step of operating a measurement system for measuring the output power level of the power amplifier (103) in the first mode switching step and suspending an operation of the measurement system in the second mode switching step.

8. The transmitting method according to claim 1, wherein the first mode switching step comprises a determining step of, when deciding an operation mode switch from the uncompressed mode to the compressed mode, determining whether to switch the uncompressed mode to the compressed mode or maintain the uncompressed mode, based on a first output power level of the amplifier before the operation mode switch and a second output level of the power amplifier (103) after the operation mode switch.

9. The transmitting method according to claim 8, further comprising a controlling step of, when the operation mode is decided to switch to the compressed mode, controlling the first output power level of the power amplifier (103) in the uncompressed mode before the operation mode switch to be closer to the second output power level of the power amplifier (103) in the compressed mode after the operation mode switch.

10. The transmitting method according to claim 1, wherein, when the power amplifier (103) is operated in the uncompressed mode, the output power level of the power amplifier (103) is controlled by changing a power level of a phase modulation radio frequency signal received as input in a radio frequency signal input terminal of the power amplifier (103).

11. The transmitting method according to claim 1, wherein, when the power amplifier (103) is operated in the compressed mode, the output power level of the power amplifier (103) is controlled by changing an amplitude of a power supply received as supply in a power supply input terminal of the power amplifier (103).

12. The transmitting method according to claim 11, wherein, when the output power level of the power amplifier (103) is controlled by changing the amplitude of the power supply received as supply in the power supply input terminal of the power amplifier (103), a phase modulation radio frequency signal of a constant amplitude is supplied to a radio frequency signal input terminal of the power amplifier (103).

13. A polar modulation transmitting apparatus comprising:

a power amplifier (103) configured to support two operation modes of a compressed mode and an uncompressed mode; and
a power supply voltage forming section (104) configured to form a power supply voltage based on an amplitude component signal and to supply the power supply voltage to a power supply input terminal of the power amplifier (103);
a phase modulation radio frequency signal forming section (102, 105) configured to form a phase modulation radio frequency signal and to supply the phase modulation radio frequency signal to a radio frequency signal input terminal of the power amplifier (103);
a measuring section configured to measure a an output power level of the power amplifier (103); and
a transmission power controlling section (107) configured to switch between the two operation modes by controlling the phase modulation radio frequency signal and the power supply voltage supplied to the power amplifier (103),
wherein the transmission power controlling section (107) is configured to support a first mode for switching mode with reference to a measurement result in the measuring section and a second mode without reference to the measurement result.

**14.** The polar modulation transmitting apparatus according to claim 13, wherein the transmission power controlling section (107) is configured to select between performing the first mode and performing the second mode based on a transmission power control signal including information about a change level in transmission power.

**15.** The polar modulation transmitting apparatus according to claim 13, wherein the transmission power controlling section (107) comprises an overlap power level region in which the power amplifier (103) can be controlled at substantially equal output power levels in both operation modes of the compressed mode and the uncompressed mode, and is configured to select between performing the first mode and performing the second mode based on whether or not the output power level to control is within the range of the overlap power level region.

**16.** The polar modulation transmitting apparatus according to claim 13, further comprising:

a variable amplifying circuit (105) configured to amplify the phase modulation radio frequency signal based on a phase path scaling coefficient and to output the phase modulation radio frequency signal to the power amplifier (103); and
an amplitude controlling circuit configured to amplify the power supply voltage which is based on the amplitude component signal, based on an amplitude path scaling coefficient and to output the power supply voltage to the power amplifier (103), wherein, based on a measurement result in the measuring section (106), the transmission power controlling section (107) is configured to change at least one of the phase path scaling coefficient and the amplitude path scaling coefficient in a power boundary between the compressed mode and the uncompressed mode.

**Patentansprüche**

**1.** Übertragungsverfahren in einer Kommunikationsübertragungsvorrichtung, die zwei Leistungsverstärker-Betriebsmodi mit einem komprimierten Modus und einem nicht komprimierten Modus ermöglicht, wobei das Übertragungsverfahren umfasst:

einen Messschritt zur Messung eines Ausgangsleistungspegels eines Leistungsverstärkers (103);
einen ersten Modusumschaltschritt zum Umschalten zwischen dem komprimierten Modus und dem nicht komprimierten Modus mit Bezug auf den Ausgangsleistungspegel des Leistungsverstärkers (103);
einen zweiten Modusumschaltschritt zum Umschalten zwischen dem komprimierten Modus und dem nicht komprimierten Modus ohne Bezug auf den Ausgangsleistungspegel des Leistungsverstärkers (103); und
einen Auswahlschritt zum Wählen zwischen der Ausführung des ersten Modusumschaltschritts und der Ausführung des zweiten Modusumschaltschritts.

**2.** Übertragungsverfahren nach Anspruch 1, wobei der Auswahlschritt zwischen der Ausführung des ersten Modusumschaltschritts und der Ausführung des zweiten Modusumschaltschritts auf der Grundlage eines Übertragungsleistungssteuersignals auswählt, das Information über einen Änderungsbetrag der Übertragungsleistung enthält.

**3.** Übertragungsverfahren nach Anspruch 1, das ferner einen Definitionsschritt zum Definieren eines Leistungspegelüberlappungsgebiet enthält, in welchem der Leistungsverstärker (103) Leistung mit im Wesentlichen gleichen Leistungsausgangspegeln in beiden Betriebsmodi, dem komprimierten Modus und dem nicht komprimierten Modus, ausgibt.

**4.** Übertragungsverfahren nach Anspruch 3, wobei der Auswahlschritt zwischen der Ausführung des ersten Modusumschaltschritts und der Ausführung des zweiten Modusumschaltschritts auf der Grundlage davon auswählt, ob ein Leistungspegel innerhalb des Leistungspegelüberlappungsgebiets liegt.

**5.** Übertragungsverfahren nach Anspruch 3, wobei der erste und der zweite Modusumschaltschritt einen Ermittlungsschritt umfassen, um den Betriebsmodus des Leistungsverstärkers (103) aus dem komprimierten Modus und dem nicht komprimierten Modus zu ermitteln, wenn der Leistungsverstärker (103) auf der Grundlage eines Übertragungsleistungssteuersignals, das Information über einen Änderungsbetrag der Übertragungsleistung enthält, erkennt, dass der Leistungspegel in einem Bereich des Leistungspegelüberlappungsgebiets liegt.

**6.** Übertragungsverfahren nach Anspruch 5, das ferner einen Referenzschritt zum Verweisen auf eine Leistungstabelle aufweist, die einen Soll-Ausgangsleistungspegel im Voraus enthält, wenn der Leistungsverstärker (103) in dem vorbestimmten Betriebsmodus betrieben wird.

7. Übertragungsverfahren nach Anspruch 1, wobei der Auswahlschritt ferner einen Schritt zum Betreiben eines Messsystems zum Messen des Ausgangsleistungspegels des Leistungsverstärkers (103) in dem ersten Modusumschaltschritt und zur Unterbrechung eines Betriebs des Messsystems in dem zweiten Modusumschaltschritt umfasst.

8. Übertragungsverfahren nach Anspruch 1, wobei der erste Modusumschaltschritt einen Ermittlungsschritt umfasst, um zu ermitteln, wenn eine Betriebsmodusumschaltung von dem nicht komprimierten Modus in den komprimierten Modus auszuführen ist, ob der nicht komprimierte Modus in den komprimierten Modus umzuschalten ist oder der nicht komprimierte Modus beizubehalten ist, wobei dies auf der Grundlage eines Ausgangsleistungspegels des Verstärkers vor dem Umschalten des Betriebsmodus und einem zweiten Ausgangspegel des Leistungsverstärkers (103) nach dem Umschalten des Betriebsmodus erfolgt.

9. Übertragungsverfahren nach Anspruch 8, das ferner einen Steuerschritt umfasst, um den ersten Ausgangspegel des Leistungsverstärkers (103) in dem nicht komprimierten Modus vor dem Umschalten des Betriebsmodus so zu steuern, dass er näher an dem zweiten Ausgangsleistungspegel des Leistungsverstärkers (103) in dem komprimierten Modus nach dem Umschalten des Betriebsmodus liegt, wenn der Betriebsmodus in den komprimierten Modus umzuschalten ist.

10. Übertragungsverfahren nach Anspruch 1, wobei, wenn der Leistungsverstärker (103) in dem nicht komprimierten Modus betrieben wird, der Ausgangsleistungspegel des Leistungsverstärkers (103) gesteuert wird, indem ein Leistungspegel eines Phasenmodulations-Funkfrequenzsignals geändert wird, das als Eingangssignal an einem Funkfrequenzsignal-Eingangsanschluss des Leistungsverstärkers (103) empfangen wird.

11. Übertragungsverfahren nach Anspruch 1, wobei, wenn der Leistungsverstärker (103) in dem komprimierten Modus betrieben wird, der Ausgangsleistungspegel des Leistungsverstärkers (103) gesteuert wird, indem eine Amplitude einer Leistungsversorgung, die als zugeführte Leistung an einem Leistungsversorgungs-Eingangsanschluss des Leistungsverstärkers (103) empfangen wird, geändert wird.

12. Übertragungsverfahren nach Anspruch 11, wobei, wenn der Ausgangsleistungspegel des Leistungsverstärkers (103) gesteuert wird durch Änderung der Amplitude der als Leistungsversorgung in dem Leistungsversorgungs-Eingangsanschluss des Leistungsverstärkers (103) empfangenen Leistungsversorgung, ein Phasenmodulations-Funkfrequenzsignal mit konstanter Amplitude einem Funkfrequenzsignal-Eingangsanschluss des Leistungsverstärkers (103) zugeführt wird.

13. Polare Modulationsübertragungsvorrichtung, mit:

einem Leistungsverstärker (103), der ausgebildet ist, zwei Betriebsmodi mit einem komprimierten Modus und einem nicht komprimierten Modus zu ermöglichen; und

einem Leistungsversorgungsspannungs-Erzeugungsabschnitt (104), der ausgebildet ist, eine Leistungsversorgungsspannung auf der Grundlage eines Amplitudenkomponentensignals zu erzeugen und die Leistungsversorgungsspannung einem Leistungsversorgungs-Eingangsanschluss des Leistungsverstärkers (103) zuzuführen;

einem Phasenmodulations-Funkfrequenzsignal-Erzeugungsabschnitt (102, 105), der ausgebildet ist, ein Phasenmodulations-Funkfrequenzsignal zu erzeugen und das Phasenmodulations-Funkfrequenzsignal einem Funkfrequenzsignal-Eingangsanschluss des Leistungsverstärkers (103) zuzuführen;

einem Messabschnitt, der ausgebildet ist, einen Ausgangsleistungspegel des Leistungsverstärkers (103) zu messen; und

einem Übertragungsleistungssteuerungsabschnitt (107), der ausgebildet ist, zwischen den zwei Betriebsmodi umzuschalten, durch Steuern des Phasenmodulations-Funkfrequenzsignals und der Leistungsversorgungsspannung, die dem Leistungsverstärker (103) zugeführt werden,

wobei der Übertragungsleistungssteuerungsabschnitt (107) ausgebildet ist, einen ersten Modus zum Umschalten des Modus mit Bezug auf ein Messergebnis des Messabschnitts und einen zweiten Modus ohne Bezug auf das Messergebnis zu ermöglichen.

14. Polare Modulationsübertragungsvorrichtung nach Anspruch 13, wobei der Übertragungsleistungssteuerungsabschnitt (107) ausgebildet ist, zwischen der Ausführung des ersten Modus und der Ausführung des zweiten Modus auf der Grundlage eines Übertragungsleistungssteuersignals auszuwählen, das Information über eine Betragsänderung der Ausgangsleistung enthält.

**15.** Polare Modulationsübertragungsvorrichtung nach Anspruch 13, wobei der Übertragungsleistungssteuerungsabschnitt (107) ein Leistungspegelüberlappungsgebiet aufweist, in welchem der Leistungsverstärker (103) mit im Wesentlichen gleichen Ausgangsleistungspegeln in beiden Betriebsmodi, dem komprimierten Modus und dem nicht komprimierten Modus, steuerbar ist und ausgebildet ist, zwischen dem Ausführen des ersten Modus und dem Ausführen des zweiten Modus auf der Grundlage davon auszuwählen, ob der zu steuernde Ausgangspegel innerhalb des Bereichs des Leistungspegelüberlappungsgebiets liegt oder nicht.

**16.** Polare Modulationsübertragungsvorrichtung nach Anspruch 13, die ferner umfasst:

eine Schaltung mit variabler Verstärkung (105), die ausgebildet ist, das Phasenmodulations-Funkfrequenzsignal auf der Grundlage eines phasenseitigen Skalierungskoeffizienten zu verstärken und das Phasenmodulations-Funkfrequenzsignal an den Leistungsverstärker (103) auszugeben; und

eine Amplitudensteuerschaltung, die ausgebildet ist, die Leistungsversorgungsspannung, die auf dem Amplitudenkomponentensignal beruht, auf der Grundlage eines amplitudenseitigen Skalierungskoeffizienten zu verstärken und die Leistungsversorgungsspannung an den Leistungsverstärker (103) auszugeben, wobei auf der Grundlage eines Messergebnisses des Messabschnitts (106) der Übertragungsleistungssteuerungsabschnitt (107) ausgebildet ist, den phasenseitigen Skalierungskoeffizienten und/oder den amplitudenseitigen Skalierungskoeffizienten in einem Leistungsgrenzbereich zwischen dem komprimierten Modus und dem nicht komprimierten Modus zu ändern.

## Revendications

**1.** Procédé de transmission dans un appareil de transmission de communication prenant en charge deux modes d'opération d'amplificateur de puissance comprenant un mode compressé et un mode non compressé, le procédé de transmission comprenant :

une étape de mesure consistant à mesurer un niveau de puissance de sortie d'un amplificateur de puissance (103) ;

une première étape de commutation de mode consistant à commuter entre le mode compressé et le mode non compressé en se référant au niveau de puissance de sortie de l'amplificateur de puissance (103) ;

une seconde étape de commutation de mode consistant à commuter entre le mode compressé et le mode non compressé sans se référer au niveau de puissance de sortie de l'amplificateur de puissance (103) ; et

une étape de sélection consistant à choisir entre l'exécution de la première étape de commutation de mode et l'exécution de la seconde étape de commutation de mode.

**2.** Procédé de transmission selon la revendication 1, où l'étape de sélection consiste à choisir entre l'exécution de la première étape de commutation de mode et l'exécution de la seconde étape de commutation de mode en se fondant sur un signal de commande de puissance de transmission incluant une information concernant un niveau de changement de la puissance de transmission.

**3.** Procédé de transmission selon la revendication 1, comprenant en outre une étape de définition consistant à définir une région de superposition de niveaux de puissance dans laquelle l'amplificateur de puissance (103) sort une puissance à des niveaux de puissance de sortie sensiblement égaux dans les deux modes de fonctionnement que sont le mode compressé et le mode non compressé.

**4.** Procédé de transmission selon la revendication 3, où l'étape de sélection consiste à choisir entre l'exécution de la première étape de commutation de mode et l'exécution de la seconde étape de commutation de mode en fonction de si un niveau de puissance est compris dans la région de superposition de niveaux de puissance.

**5.** Procédé de transmission selon la revendication 3, où les première et seconde étapes de commutation de mode comprennent une étape de détermination consistant à déterminer si le mode de fonctionnement de l'amplificateur de puissance (103) est le mode compressé ou le mode non compressé quand l'amplificateur de puissance (103) décide que le niveau de puissance est compris dans la région de superposition de niveaux de puissance, en se fondant sur un signal de commande de puissance de transmission incluant des informations concernant un niveau de changement de la puissance de transmission.

**6.** Procédé de transmission selon la revendication 5, comprenant en outre une étape de renvoi consistant à se référer à un tableau de puissance enregistrant préalablement un niveau de puissance de sortie cible quand l'amplificateur de puissance (103) fonctionne selon le mode de fonctionnement déterminé.

**7.** Procédé de transmission selon la revendication 1, où l'étape de sélection comprend en outre une étape consistant à actionner un système de mesure pour mesurer le niveau de puissance de sortie de l'amplificateur de puissance (103) lors de la première étape de commutation de mode et suspendre un fonctionnement du système de mesure lors de la seconde étape de commutation de mode.

**8.** Procédé de transmission selon la revendication 1, où la première étape de commutation de mode comprend une étape de détermination consistant à déterminer, au moment de décider d'une commutation de mode de fonctionnement du mode non compressé au mode compressé, s'il faut basculer du mode non compressé au mode compressé ou s'il faut maintenir le mode non compressé, en se fondant sur un premier niveau de puissance de sortie de l'amplificateur avant la commutation de mode de fonctionnement et un second niveau de puissance de sortie de l'amplificateur de puissance (103) après la commutation de mode de fonctionnement.

**9.** Procédé de transmission selon la revendication 8, comprenant en outre une étape de commande consistant, lorsqu'une commutation du mode de fonctionnement vers le mode compressé est décidée, à commander le premier niveau de puissance de sortie de l'amplificateur de puissance (103) dans le mode non compressé, avant la commutation du mode de fonctionnement, de manière à ce qu'il soit plus proche du second niveau de puissance de sortie de l'amplificateur de puissance (103) dans le mode compressé, après la commutation du mode de fonctionnement.

**10.** Procédé de transmission selon la revendication 1, où, lorsque l'amplificateur de puissance (103) fonctionne selon le mode non compressé, le niveau de puissance de sortie de l'amplificateur de puissance (103) est commandé en changeant un niveau de puissance d'un signal radiofréquence à modulation de phase reçu en entrée au niveau d'une borne d'entrée de signal radiofréquence de l'amplificateur de puissance (103).

**11.** Procédé de transmission selon la revendication 1, où, lorsque l'amplificateur de puissance (103) fonctionne selon le mode compressé, le niveau de puissance de sortie de l'amplificateur de puissance (103) est commandé de manière à changer une amplitude d'une alimentation électrique reçue au niveau d'une borne d'entrée d'alimentation électrique de l'amplificateur de puissance (103).

**12.** Procédé de transmission selon la revendication 11, où, lorsque le niveau de puissance de sortie de l'amplificateur de puissance (103) est commandé en changeant l'amplitude de l'alimentation électrique reçue au niveau de la borne d'entrée d'alimentation électrique de l'amplificateur de puissance (103), un signal radiofréquence à modulation de phase d'amplitude constante est fourni à une borne d'entrée de signal radiofréquence de l'amplificateur de puissance (103).

**13.** Appareil de transmission à modulation polaire comprenant :

un amplificateur de puissance (103) configuré pour prendre en charge deux modes d'opération comprenant un mode compressé et un mode non compressé ; et
une section de formation de tension d'alimentation électrique (104) configurée pour former une tension d'alimentation électrique en se fondant sur un signal de composante d'amplitude et pour fournir la tension d'alimentation électrique à une borne d'entrée d'alimentation électrique de l'amplificateur de puissance (103) ;
une section de formation de signal radiofréquence à modulation de phase (102, 105) configurée pour former un signal radiofréquence à modulation de phase et pour fournir le signal radiofréquence à modulation de phase à une borne d'entrée de signal radiofréquence de l'amplificateur de puissance (103) ;
une section de mesure configurée pour mesurer un niveau de puissance de sortie de l'amplificateur de puissance (103) ; et
une section de commande de puissance de transmission (107) configurée pour basculer entre les deux modes de fonctionnement en commandant le signal radiofréquence à modulation de phase et la tension d'alimentation électrique fournie à l'amplificateur de puissance (103),
où la section de commande de puissance de transmission (107) est configurée pour prendre en charge un premier mode pour commuter un mode en se référant à un résultat de mesure effectuée dans la section de mesure et un second mode ne se référant pas au résultat de mesure.

**14.** Appareil de transmission à modulation polaire selon la revendication 13, où la section de commande de puissance de transmission (107) est configurée pour choisir entre l'exécution du premier mode et l'exécution du second mode en se fondant sur un signal de commande de puissance de transmission incluant une information concernant un niveau de changement de la puissance de transmission.

**15.** Appareil de transmission à modulation polaire selon la revendication 13, où la section de commande de puissance de transmission (107) comprend une région de superposition de niveaux de puissance dans laquelle l'amplificateur de puissance (103) peut être commandé avec des niveaux de puissance de sortie sensiblement égaux dans les deux modes de fonctionnement que sont le mode compressé et le mode non compressé, et est configuré pour choisir entre l'exécution du premier mode et l'exécution du second mode en fonction de si un niveau de puissance de sortie à commander est compris dans la région de superposition de niveaux de puissance.

**16.** Appareil de transmission à modulation polaire selon la revendication 13, comprenant en outre :

un circuit d'amplification variable (105) configuré pour amplifier le signal radiofréquence à modulation de phase en se fondant sur un coefficient de mise à l'échelle de trajectoire de phase et pour sortir le signal radiofréquence à modulation de phase à destination de l'amplificateur de puissance (103) ; et
un circuit de commande d'amplitude configuré pour amplifier la tension d'alimentation électrique fondée sur le signal de composante d'amplitude, en se fondant sur un coefficient de mise à l'échelle de trajectoire d'amplitude et pour sortir la tension d'alimentation électrique à destination de l'amplificateur de puissance (103), où la section de commande de puissance de transmission (107) est configurée pour changer, en se fondant sur un résultat de mesure effectuée dans la section de mesure (106), au moins un des coefficients que sont le coefficient de mise à l'échelle de trajectoire de phase et le coefficient de mise à l'échelle de trajectoire d'amplitude au niveau d'une délimitation de puissance entre le mode compressé et le mode non compressé.

TRANSMISSION POWER CONTROL
SIGNAL

ENVELOPE COMPONENT
SIGNAL

1

2

INPUT SIGNAL

POLAR SIGNAL
GENERATING CIRCUIT

AMPLITUDE CONTROLLING
CIRCUIT

PHASE COMPONENT
SIGNAL

5

3

PHASE MODULATION SIGNAL
GENERATING CIRCUIT

PA

4

FIG.1

EP 2 091 144 B1

FIG.2

| TPC COMMAND | TRANSMISSION POWER CONTROL RANGE | | | | | |
|---|---|---|---|---|---|---|
| | 1dBSTEP SIZE | | 2dBSTEP SIZE | | 3dBSTEP SIZE | |
| | LOWER SIDE | UPPER SIDE | LOWER SIDE | UPPER SIDE | LOWER SIDE | UPPER SIDE |
| 1 | +0.5dB | +1.5dB | +1dB | +3dB | +1.5dB | +4.5dB |
| 0 | −0.5dB | +0.5dB | −0.5dB | +0.5dB | −0.5dB | +0.5dB |
| -1 | −0.5dB | −1.5dB | −1dB | −3dB | −1.5dB | −4.5dB |

FIG.3

| TARGET STEP SIZE | STEP SIZE TOLERANCE VALUES |
|---|---|
| 0dB | +/−0.5dB |
| 1dB | +/−0.5dB |
| 2dB | +/−1.0dB |
| 3dB | +/−1.5dB |
| 4−10dB | +/−2.0dB |
| 11−15dB | +/−3.0dB |
| 16−20dB | +/−4.0dB |
| ≥21dB | +/−6.0dB |

← ⌁MOST RESTRICTIVE

## FIG.4

| TPC COMMAND GROUP | TRANSMISSION POWER CONTROL RANGE AFTER 10 EQUAL TPC COMMAND GROUPS ARE PERFORMED | | | | TRANSMISSION POWER CONTROL RANGE AFTER 7 EQUAL TPC COMMAND GROUPS ARE PERFORMED | |
|---|---|---|---|---|---|---|
| | 1dBSTEP SIZE | | 2dBSTEP SIZE | | 3dBSTEP SIZE | |
| | LOWER SIDE | UPPER SIDE | LOWER SIDE | UPPER SIDE | LOWER SIDE | UPPER SIDE |
| +1 | +8dB | +12dB | +16dB | +24dB | +16dB | +26dB |
| 0 | +1dB | +1dB | −1dB | +1dB | −1dB | +1dB |
| −1 | −8dB | −12dB | −16dB | −24dB | −16dB | −26dB |
| 0,0,0,0,+1 | +6dB | +14dB | N/A | N/A | N/A | N/A |
| 0,0,0,0,−1 | −6dB | −14dB | N/A | N/A | N/A | N/A |

IN THIS TABLE, THESE REQUIREMENTS ARE THE MOST RESTRICTIVE (AFTER 10 EQUAL STEPS WHICH ARE EACH 1 dB ARE PERFORMED, POWER DIFFERENCE MUST BE WITHIN 10 ± 2 dB)

## FIG.5

FIG.6

SET VALUE
(AM or PM)

COMPRESSED MODE

UNCOMPRESSED MODE

AMPLITUDE PATH SCALING
COEFFICIENT

EXTENDED UNCOMPRESSED MODE

CALIBRATION REGION

EXTENDED
COMPRESSED
MODE

PHASE PATH SCALING
COEFFICIENT

OVERLAP
REGION

EXTENDED UNCOMPRESSED MODE

FIG.7

ACTUAL OUTPUT POWER

COMPRESSED MODE

CORRECTION

$P_{c, min}$

UNCOMPRESSED MODE

UNCOMPRESSED MODE

DETECT DRIFT AMOUNT

$P_{c, min}$

POWER COMMAND

FIG.8

26

FIG.9

FIG.10

FIG.11

FIG.12A

FIG.12B

FIG.12C

FIG.13

FIG.14

FIG.15

FIG.16

FIG.17

FIG.18

FIG.19

HIGH POWER

COMPRESSED REGION

- - - - - Pu, max

OVERLAP REGION

Pc, min - - - - - - - Pd, min

Pda - - - - - - - - - - - - - -

UNCOMPRESSED REGION

LOW POWER

FIG.20

FIG.21

FIG.22

EP 2 091 144 B1

37

FIG.23A

FIG.23B

FIG.23C

FIG.24A

FIG.24B

EP 2 091 144 B1

**EP 2 091 144 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006046666 A1